# EUROPÄISCHE PATENTSCHRIFT

(11) **EP 2 497 129 B1**
(45) Veröffentlichungstag und Bekanntmachung des Hinweises auf die Patenterteilung: **21.05.2014**
(21) Anmeldenummer: 10787681.5
(22) Anmeldetag: 27.10.2010
(51) Int. Cl.: H01L 41/09

(54) **AKTUATOR**
ACTUATOR
ACTIONNEUR

(30) Priorität: 02.11.2009 DE 102009051395
(43) Veröffentlichungstag der Anmeldung: 12.09.2012
(73) Patentinhaber: Physik Instrumente (PI) GmbH & Co. KG, 76228 Karlsruhe (DE)
(72) Erfinder: WISCHNEWSKIY, Wladimir, 77337 Waldbronn (DE); WISCHNEWSKIJ, Alexej, 76744 Wörth (DE)
(74) Vertreter: Grünecker, Kinkeldey, Stockmair & Schwanhäusser
(86) Internationale Anmeldenummer: PCT/DE2010/001254
(87) Internationale Veröffentlichungsnummer: WO 2011/050784

(56) Entgegenhaltungen:
- DE-A1-102004 024 656
- US-A1- 2003 178 915
- US-A1- 2009 039 736

## Beschreibung

Die Erfindung betrifft einen Aktuator, vorzugsweise einen piezoelektrischen Aktuator, in Form einer Platte, umfassend zumindest zwei Generatoren zur Erregung einer akustischen Stehwelle im Aktuator, wobei der Aktuator wenigstens zwei Hauptflächen und eine senkrecht zu den Hauptflächen verlaufende Symmetrieebene S, bezüglich derer die Generatoren symmetrisch angeordnet sind, aufweist und an einem ersten, im Wesentlichen ebenen Seitenflächenbereich des Aktuators wenigstens ein Friktionselement und/oder wenigstens eine Friktionsschicht, das/die zum Friktionskontakt mit einem anzutreibenden Element vorgesehen ist/sind, angeordnet ist/sind und der erste Seitenflächenbereich eine Länge L aufweist, die im Wesentlichen der Wellenlänge der im Aktuator erregten akustischen Stehwelle entspricht.

Aus der veröffentlichten Anmeldeschrift DE 10 2004 024 656 A1 ist ein solcher Aktuator in Form einer rechteckigen piezoelektrischen Platte bekannt. Die in ihm erregte akustische Stehwelle breitet sich entlang der zwei langen Stirnseiten des Aktuators aus, da die Länge besagter Stirnseiten die Resonanzlänge für die akustische Stehwelle darstellt. Die Deformation des Aktuators dieses Motors erfolgt symmetrisch zu seiner Längssymmetrieebene. Das bedeutet, dass sich der Aktuator des Motors aufgrund der inneren Reibung symmetrisch zu seiner Längssymmetrieebene erwärmt. Die Seite des Aktors, auf der sich kein Friktionselement befindet, erwärmt sich genauso wie die Seite, auf der sich das Friktionselement befindet. Deshalb treten in dem Aktuator aufgrund innerer Reibung deutliche Energieverluste auf.

Hinzu tritt beim Einsatz des Aktuators in einem entsprechenden Motor äußere Reibung an den Stellen, wo der Aktuator von außen unterstützt wird, d.h. an den Befestigungs- oder Halterungspunkten. Da der Aktuator auch dort noch eine signifikante Schwinggeschwindigkeit aufweist, entsteht hier aufgrund besagter äußerer Reibung zusätzliche Wärme, die zumindest teilweise in den Aktuator eingetragen wird.

Aufgrund der durch die innere und äußere Reibung des Aktuators bedingten mechanischen Verluste verringert sich insgesamt die Schwingungsgeschwindigkeit des Aktuators und damit die Bewegungsgeschwindigkeit eines durch den Aktuator anzutreibenden Elements. Hierdurch ergibt sich eine Reduzierung des Wirkungsgrads eines entsprechenden Motors. Gleichzeitig führt die durch innere und äußere Reibung hervorgerufene Erwärmung des Aktuators zu mechanischen Verlusten, wodurch die Betriebssicherheit des Aktuators abnimmt.

Daher ist es Ziel der Erfindung, einen Aktuator bereitzustellen, bei dem im Betrieb eine deutliche Verringerung der inneren und äußeren Reibung und dementsprechend eine geringere Eigenerwärmung auftritt, und der daher einen erhöhten Wirkungsgrad und eine bessere Betriebssicherheit aufweist.

Diese Aufgabe wird gelöst durch einen Aktuator der eingangs genannten Art, welcher derart weitergebildet ist, dass ein zweiter Seitenflächenbereich des Aktuators eine Länge B aufweist, die größer als die Wellenlänge der im Aktuator erregten akustischen Stehwelle und ungleich einem Vielfachen der halben Wellenlänge der erregten akustischen Stehwelle ist.

Der Aktuator wird vorzugsweise so elektrisch angesteuert, dass zumindest ein Generator zu Schwingungen mit einer Frequenz angeregt wird, die im Wesentlichen der Resonanzfrequenz der zweiten Mode der Longitudinalschwingung des ersten Seitenflächenbereichs entspricht. Dadurch breitet sich entlang des ersten Seitenflächenbereichs bzw. an dessen Oberfläche (Resonanzoberfläche) eine akustische Welle aus, deren Länge der Länge L des ersten Seitenflächenbereichs entspricht.

Da der zweite Seitenflächenbereich eine Länge B aufweist, die keinem Vielfachen der halben Wellenlänge der im Aktuator erregten Welle entspricht, breitet sich entlang des zweiten Seitenflächenbereichs bzw. entlang deren Oberfläche auch keine akustische Welle aus. Somit stellt für diese Frequenz die Oberfläche des zweiten Seitenflächenbereichs keine Resonanzoberfläche dar (Nicht-Resonanzoberfläche).

Das bedeutet, dass die sich auf der Resonanzoberfläche befindenden Materialpunkte des Aktuators eine größere mittlere Amplitude aufweisen, als die auf der Nicht-Resonanzoberfläche liegenden Materialpunkte. Deshalb kann bei dem erfindungsgemäßen Aktuator quasi ein Resonanzgebiet ausgewiesen werden, in dem Resonanzschwingungen des Aktuators entstehen. Außerhalb dieses Resonanzgebietes befindet sich ein Nicht-Resonanzgebiet für den Aktuator. Innerhalb des Resonanzgebietes ist daher die mittlere Schwingungsamplitude der Materialpunkte größer als in den übrigen Gebieten des Aktuators. Daraus folgt, dass die mechanischen Verluste bzw. die Erwärmung durch innere Reibung in dem Nicht-Resonanzgebiet kleiner sind als in dem Resonanzgebiet.

Bei Halterung bzw. Befestigung des erfindungsgemäßen Aktuators an Stellen bzw. Punkten der Nicht-Resonanzoberfläche ergeben sich dort aufgrund der geringeren Schwingungsgeschwindigkeit der Materialpunkte an dieser Oberfläche verringerte mechanische Verluste durch äußere Reibung.

Durch die Verringerung der mechanischen Verluste aufgrund innerer und äußerer Reibung in den Nicht-Resonanzgebieten verringert sich insgesamt die Erwärmung des Aktuators, wodurch eine größere Effektivität und eine höhere Betriebssicherheit erreicht werden.

Als weiterer Vorteil kommt hinzu, dass der erfindungsgemäße Aktuator bei gleicher Resonanzlänge L ein deutlich geringeres Volumen als der aus dem Stand der Technik gemäß Druckschrift DE 10 2004 024 656 A1 bekannte Aktuator aufweist. Dieser Umstand verringert ebenfalls die mechanischen Verluste im Aktuator.

Die Verringerung der mechanischen Verluste ermöglicht es, bei gleicher Erregerspannung die Schwingungsgeschwindigkeit des Friktionselementes und damit die Bewegungsgeschwindigkeit eines durch den Aktuator anzutreibenden Elements zu erhöhen. Dadurch erhöht sich der Wirkungsgrad eines entsprechenden Motors.

Durch die geringeren mechanischen Verluste aufgrund reduzierter innerer und äußerer Reibung verringert sich auch die aktive Komponente der elektrischen Eingangsimpedanz des Aktuators für den erfindungsgemäßen Aktuator im Verhältnis zur kapazitiven Komponente dieser Impedanz. Das wiederum verringert den Ladestrom der Eingangskapazität des Aktuators und des kapazitiven Stromes im Verhältnis zur aktiven Komponente des durch den Aktuator fließenden Stroms.

Beides führt zu geringeren Verlusten in einem für die elektrische Erregung des Aktuators verwendeten Leistungsverstärker, wodurch sich die Erwärmung der Transistoren im Leistungsverstärker verringert. Daher ist es bei dem erfindungsgemäßen Aktuator beispielsweise möglich, die Generatoren der akustischen Welle direkt mit einem Brückenleistungsverstärker ohne den Einsatz eines sonst üblichen Trennfilters zu verbinden. Dies vereinfacht den Aufbau der elektrischen Erregervorrichtung, verringert die Erwärmung dieser und erhöht die Betriebssicherheit des Motors.

Bevorzugte Ausgestaltungen des erfindungsgemäßen Aktuators sind Gegenstand der Unteransprüche.

Es kann von Vorteil sein, dass der zweite Seitenflächenbereich zumindest eine der folgenden Anforderungen erfüllt:
a) der zweite Seitenflächenbereich ist zumindest abschnittsweise gekrümmt;
b) der zweite Seitenflächenbereich besteht aus zumindest einem konkaven und/oder zumindest einem konvexen Abschnitt besteht;
c) der zweite Seitenflächenbereich ist zumindest abschnittsweise eben;
d) der zweite Seitenflächenbereich besteht aus zwei oder mehr gegenüber dem ersten Seitenflächenbereich unterschiedlich orientierten ebenen Abschnitten;
e) der zweite Seitenflächenbereich besteht aus ebenen und gekrümmten Abschnitten.

Derartige Ausgestaltungen des Aktuators erweitern die konstruktiven Möglichkeiten und erlauben beispielsweise eine gezielte Anpassung an die geometrischen bzw. strukturellen Gegebenheiten, in denen der Aktuator zur Anwendung kommt bzw. in denen der Aktuator Verwendung findet. Hierbei ist es denkbar, dass der zweite Seitenflächenbereich einflächig oder mehrflächig ausgestaltet ist. Bei mehrflächiger Ausgestaltung ist zudem denkbar, dass der zweite Seitenflächenbereich eine Aneinanderreihung von ebenen und gekrümmten Abschnitten aufweist.

Insbesondere kann es hierbei von Vorteil sein, dass der Aktuator zumindest eine der folgenden Anforderungen erfüllt:
a) der Aktuator hat in Draufsicht die Form eines Kreisabschnitts oder eines Ellipsenabschnitts;
b) der Aktuator hat in Draufsicht die Form eines gleichschenkligen Trapezes.

Diese geometrischen Formen sind vergleichsweise einfach herzustellen.

Weiterhin kann es von Vorteil sein, dass auf dem zweiten Seitenflächenbereich zumindest ein Punkt existiert, dessen Abstand zum Schnittpunkt der Symmetrieebene S mit dem ersten Seitenflächenbereich im Wesentlichen der halben Wellenlänge der im Aktuator erregten Welle entspricht. Dies erhöht den Wirkungsgrad des Motors.

Außerdem kann es von Vorteil sein, dass das Friktionselement und/oder die Friktionsschicht zumindest eine der folgenden Anforderungen erfüllt/erfüllen:
a) das Friktionselement und/oder die Friktionsschicht ist/sind symmetrisch bezüglich der Symmetrieebene S angeordnet;
b) das Friktionselement und/oder die Friktionsschicht ist/sind entlang des gesamten ersten Seitenflächenbereichs angeordnet.

Dies erweitert die konstruktiven Möglichkeiten des Aktuators.

Zudem kann es vorteilhaft sein, dass der Aktuator im Betrieb Schwingungen im Ultraschallbereich vollführt. Hierdurch ergibt sich ein erweitertes Anwendungsspektrum für den Aktuator.

Ebenso kann es vorteilhaft sein, dass der Aktuator einschichtig oder mehrschichtig ist, wobei die Schicht/Schichten ein piezoelektrisches Material, vorzugsweise ein piezokeramisches Material aufweist/aufweisen. Ein einschichtiger Aufbau ist vergleichsweise einfach realisierbar. Bei einem mehrschichtigen Aufbau kann die elektrische Erregerspannung gegenüber einem einschichtigen Aufbau deutlich reduziert werden. Piezokeramische Materialien weisen in der Regel einen vergleichsweise hohen (inversen) piezoelektrischen Effekt auf und sind somit besonders effektiv.

Die Erfindung betrifft zudem einen Motor mit zumindest einem Aktuator nach einer der vorstehenden vorteilhaften Ausführungsformen, wobei der Motor zusätzlich ein anzutreibendes Element und eine elektrische Erregervorrichtung aufweist.

Hierbei kann es günstig sein, dass der Motor vier Aktuatoren jeweils in Form eines gleichschenkeligen Trapezes aufweist, wobei diese so angeordnet sind, das sie ein Malteserkreuz bilden. Hier kann es vorteilhaft sein, wenn die Aktuatoren miteinander mit Hilfe eines Verbindungselementes verbunden sind, wobei das Verbindungselement zumindest abschnittsweise Kontakt mit dem zweiten Seitenflächenbereich jedes Aktuators hat. Weiterhin kann es dabei günstig sein, dass das Verbindungselement ein schallisolierendes Material aufweist und vorzugsweise aus diesem besteht, wobei das schallisolierende Material vorzugsweise eine Oxidkeramik ist oder aus dem gleichen Material wie der Aktuator besteht. Dadurch entsteht ein besonders effektiver und betriebssicherer Motor.

Es kann auch günstig sein, dass der Aktuator des Motors ein Rückkopplungselement aufweist. In bevorzugter Ausgestaltung ist dessen Ausgang mit einem Filter für die erste Harmonische seiner Eingangsspannung verbunden. Dies ermöglicht die optimale Bestimmung der Frequenz der Erregerspannung für den Aktuator des Motors.

Ebenso kann es günstig sein, dass die die elektrische Erregervorrichtung des Motors zumindest eine der folgenden Anforderungen erfüllt:
a) die elektrische Erregervorrichtung weist einen Umschalter auf, der zum Verbinden von ihr mit einem der Generatoren zur Erregung einer rechtsgeneigten oder linksgeneigten asymmetrischen Stehwelle im Aktuator dient;
b) die elektrische Erregervorrichtung stellt eine periodische asymmetrische elektrische Spannung bereit, wobei die Generatoren gegenphasig miteinander verbunden sind;
c) die elektrische Erregervorrichtung weist einen Halbbrücken- oder Brückenleistungsverstärker auf, der direkt oder über einen Aufspanntransformator mit einem Generator oder mit beiden Generatoren verbunden ist;
d) die elektrische Erregervorrichtung weist einen Steuergenerator zur Erregung einer elektrischen Spannung auf, dessen Ausgang mit dem Eingang des Leistungsverstärkers verbunden ist, und der Steuereingang des Steuergenerators mit dem Ausgang eines Phasendetektors, wovon ein Messeingang direkt oder über ein Filter mit dem Ausgang des Leistungsverstärkers und ein Stützeingang direkt oder über ein Filter der ersten Harmonischen mit dem Ausgang eines Rückkopplungskreiselements verbunden ist, verbunden ist.
e) die elektrische Erregervorrichtung weist einen PWM-Controler der Spannungsversorgung des Leistungsverstärkers auf;
f) die elektrische Erregervorrichtung weist eine digitale Recheneinheit auf, welche softwaremäßig ein oder zwei Filter für die erste Harmonische, den Phasendetektor, den Steuergenerator für die elektrische Erregervorrichtung und den PWM-Modulator des PWM-Controlers der Versorgungsspannung des Leistungsverstärkers realisiert.

Durch den Umschalter wird die Möglichkeit geschaffen, die Bewegungsrichtung des anzutreibenden Elements zu ändern. Durch Vorsehen eines Halbbrücken- oder Brückenleistungsverstärkers, der direkt oder über einen Aufspanntransformator mit einem Generator oder mit beiden Generatoren verbunden ist, werden die Verluste in der elektrischen Erregervorrichtung deutlich verringert. Das Vorsehen eines Steuergenerators in zuvor erwähnter Weise ermöglicht es, die Frequenz der Erregerspannung zu stabilisieren. Durch Ausrüsten der elektrischen Erregervorrichtung mit einem PWM-Controler für die Versorgungsspannung des Leistungsverstärkers ist es möglich, die Bewegungsgeschwindigkeit des anzutreibenden Elementes zu steuern. Das Vorsehen einer digitalen Recheneinheit in oben bezeichneter Weise vereinfacht den elektrischen Schaltungsaufbau für die elektrische Erregervorrichtung.

Zudem kann es günstig sein, dass das anzutreibende Element einen Geber für die Lage oder für die Bewegungsgeschwindigkeit des anzutreibenden Elementes aufweist und die elektrische Erregervorrichtung mit einem digitalen Controller für die Lage oder die Bewegungsgeschwindigkeit des anzutreibenden Elementes ausgestattet ist. Darüber hinaus kann es günstig sein, dass der digitale Controller für die Lage oder die Bewegungsgeschwindigkeit des anzutreibenden Elementes softwaremäßig in der digitalen Recheneinheit realisiert wird. Dadurch ist es möglich, den Motor in seiner Funktion genau zu steuern.

Bevorzugte Weiterbildungen der Erfindungen ergeben sich durch Kombinationen der Unteransprüche oder Teilen davon.

### Kurze Beschreibung der Zeichnungen

Es zeigen in schematischer und nicht maßstabsgetreuer Weise:
Fig. 1: einen Motor mit einem erfindungsgemäßen Aktuator, der ein Friktionselement aufweist
Fig. 2: einen Motor mit einem erfindungsgemäßen Aktuator, der eine Friktionsschicht aufweist
Fig. 3: eine Ausführungsform eines erfindungsgemäßen Aktuators in perspektivischer Ansicht (Darstellung 13) und in Draufsicht (Darstellung 14)
Fig. 4: Darstellung 18: einen Schnitt durch einen erfindungsgemäßen einschichtigen Aktuator; Darstellung 19: einen Schnitt durch einen erfindungsgemäßen mehrschichtigen Aktuator
Fig. 5: Darstellungen 22, 25 und 26: Ausführungsformen für einen erfindungsgemäßen Aktuator
Fig. 6: Darstellungen 28 und 29: erfindungsgemäße Aktuatoren mit gekrümmtem zweiten Seitenflächenbereich
Fig. 7: Darstellungen 32 und 33: erfindungsgemäße Aktuatoren mit einem zweiten Seitenflächenbereich, der mehrere ebene Abschnitte aufweist
Fig. 8: Darstellung 34: einen erfindungsgemäßen Aktuator, bei dem die Friktionsschicht entlang des gesamten ersten Seitenflächenbereichs angeordnet ist;
Darstellung 35: einen erfindungsgemäßen Aktuator mit einem symmetrisch angeordneten Friktionselement
Fig. 9: Darstellungen 36 und 37: erfindungsgemäße Aktuatoren mit einer in Draufsicht trapezförmigen Geometrie
Fig. 10: Darstellung 41: einen erfindungsgemäßen Aktuator mit in Draufsicht trapezförmiger Geometrie; Darstellung 42: eine Anordnung von vier erfindungsgemäßen Aktuatoren gemäß Darstellung 41, die über ein Verbindungselement akustisch miteinander verbunden sind
Fig. 11: Darstellung 45: eine Draufsicht-Darstellung einer Anordnung von vier erfindungsgemäßen Aktuatoren, die im Wesentlichen dreiecksförmig sind und über ein Verbindungselement akustisch miteinander verbunden sind; Darstellung 46: eine perspektivische Darstellung der Anordnung gemäß Darstellung 45
Fig. 12: Darstellung 47: eine Draufsicht-Darstellung einer Anordnung von vier erfindungsgemäßen Aktuatoren, die über ein Verbindungselement verbunden sind und die eine Friktionsschicht aufweisen; Darstellung 48: eine perspektivische Darstellung der Anordnung gemäß Darstellung 47
Fig. 13: einen Motor mit einem erfindungsgemäßen Aktuator zum rotatorischen Antrieb eines scheibenförmigen anzutreibenden Elements
Fig. 14: Motor mit zwei gegenüberliegend angeordneten erfindungsgemäßen Aktuatoren zur Bewegung eines dazwischen angeordneten stabförmigen, anzutreibenden Elements
Fig. 15: eine Ausführungsform eines Motors mit vier erfindungsgemäßen Aktuatoren, die jeweils ein Friktionselement aufweisen
Fig. 16: eine weitere Ausführungsform eines Motors mit vier erfindungsgemäßen Aktuatoren, die jeweils ein Friktionselement aufweisen
Fig. 17: eine Ausführungsform eines Motors mit vier erfindungsgemäßen Aktuatoren, die jeweils eine Friktionsschicht aufweisen
Fig. 18: ein Blockschaltbild zur Erläuterung der Verbindung der elektrischen Erregervorrichtung mit dem Aktuator eines Motors
Fig. 19: Darstellung 54: einen erfindungsgemäßen Aktuator in Draufsicht im unerregten Zustand; Darstellungen 55 und 56: Deformationszustand des erregten Aktuators gemäß Darstellung 54 zu verschiedenen Zeitpunkten
Fig. 20: Darstellung 57: einen erfindungsgemäßen Aktuator in Draufsicht in Form eines Trapezes im unerregten Zustand; Darstellungen 58 und 59:
   Deformationszustand des erregten Aktuators gemäß Darstellung 57 zu verschiedenen Zeitpunkten
Fig. 21: eine Abbildung zur Erläuterung eines Funktionsprinzips des Motors
Fig. 22: ein Blockschaltbild zur Erläuterung der Verbindung der elektrischen Erregervorrichtung mit mehreren erfindungsgemäßen Aktuatoren, die akustisch entkoppelt sind
Fig. 23: ein Blockschaltbild zur Erläuterung der Verbindung der elektrischen Erregervorrichtung mit mehreren erfindungsgemäßen Aktuatoren, die akustisch miteinander verbunden sind
Fig. 24: ein Blockschaltbild einer Ausführungsform der elektrischen Erregervorrichtung
Fig. 25: ein Blockschaltbild einer weiteren Ausführungsform der elektrischen Erregervorrichtung
Fig. 26: ein Blockschaltbild zur Erläuterung der Verbindung der elektrischen Erregervorrichtung mit einem erfindungsgemäßen Aktuator, wobei die Generatoren gegenphasig verbunden sind (Darstellung 75) bzw. unterschiedliche Polarisationen aufweisen (Darstellung 79)
Fig. 27: eine Abbildung zur Erläuterung eines weiteren Funktionsprinzips des Motors
Fig. 28: ein Blockschaltbild einer weiteren Ausführungsform der elektrischen Erregervorrichtung
Fig. 29: ein Blockschaltbild einer weiteren Ausführungsform der elektrischen Erregervorrichtung
Fig. 30: Darstellungen 88 - 91: Blockschaltbilder zur Erläuterung von Ausführungsformen des Rückkopplungselements eines erfindungsgemäßen Aktuators
Fig. 31: ein Blockschaltbild zur Erläuterung der Verbindung des Rückkopplungselements mit einem Filter für die erste Harmonische
Fig. 32: ein Blockschaltbild zur Erläuterung des Vorsehens eines Phasendetektors
Fig. 33-35: Blockschaltbilder weiterer Ausführungsformen der elektrischen Erregervorrichtung

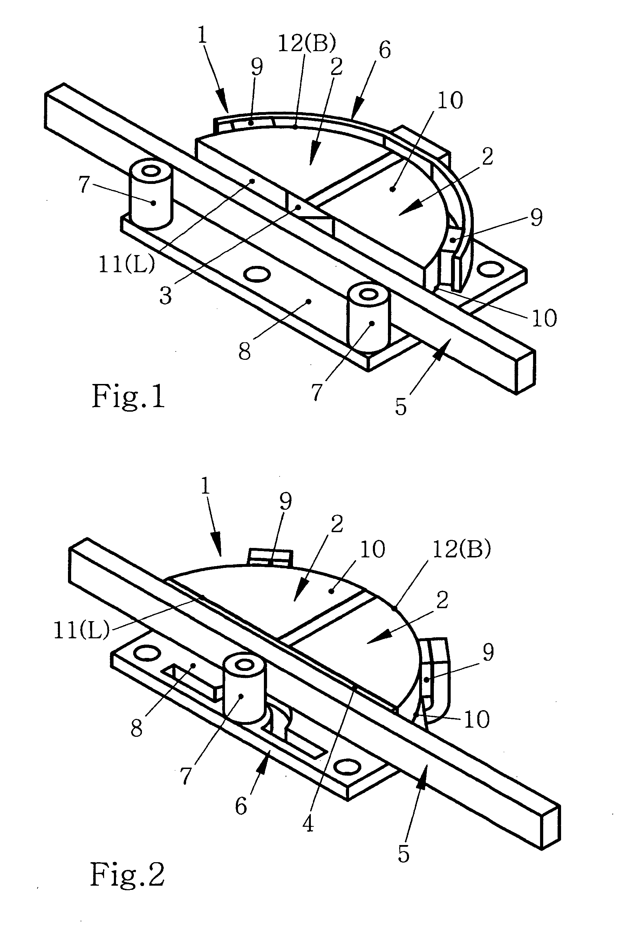

Die Figuren 1 und 2 zeigen Ausführungsvarianten von Motoren mit einem erfindungsgemäßen Aktuator. Die jeweiligen Motoren weisen einen Aktuator 1 auf, der als piezoelektrische Platte mit zwei akustischen Stehwellengeneratoren 2 ausgeführt ist und mit einem Friktionselement 3 (Fig. 1) oder einer Friktionsschicht 4 (Fig. 2) versehen ist. Das Friktionselement 3 oder die Friktionsschicht 4 wird an ein anzutreibendes Element 5 mit Hilfe eines Federelements 6 angepresst. Das anzutreibende Element 5 wird durch zwei (Fig. 1) bzw. ein (Fig. 2) Kugellager 7 gehalten und beweglich gelagert. Befestigungselemente 9 fixieren den Aktuator 1, so dass er im Bezug zum Gehäuse 8 unbeweglich ist.

Der Aktuator 1 umfasst zwei Hauptflächen 10, einen ersten Seitenflächenbereich 11 und einen zweiten Seitenflächenbereich 12. Die Oberfläche des ersten Seitenflächenbereichs 11 stellt eine Resonanzoberfläche dar, während die Oberfläche des zweiten Seitenflächenbereichs 12 eine Nicht-Resonanzoberfläche darstellt. Der erste Seitenflächenbereich weist eine ebene Form auf, d. h. die entsprechende Oberfläche ist eben. Die Länge des ersten Seitenflächenbereichs bzw. der Resonanzoberfläche beträgt L. Der zweite Seitenflächenbereich 12 hat keine ebene, sondern eine gekrümmte Oberfläche. Die Länge des zweiten Seitenflächenbereichs bzw. der Nicht-Resonanzoberfläche beträgt B. Die Länge L der Resonanzoberfläche 11 ist gleich der Wellenlänge der im Aktuator 1 erregten akustischen Welle. Die Länge B der Nicht-Resonanzoberfläche 12 ist größer als die im Aktuator 1 erregte akustische Welle und ungleich einem Vielfachen der halben Wellenlänge der erregten Welle.

Das Friktionselement 3 (Fig. 1) und die Friktionsschicht 4 (Fig. 2) sind auf der Nicht-Resonanzoberfläche 11 des Aktuators 1 angeordnet, und zwar jeweils symmetrisch zur (nicht dargestellten) Symmetrieebene S, die senkrecht zu den Hauptflächen 10 verläuft. Die Stehwellengeneratoren 2 sind ebenfalls symmetrisch zu beiden Seiten besagter Symmetrieebene S angeordnet.

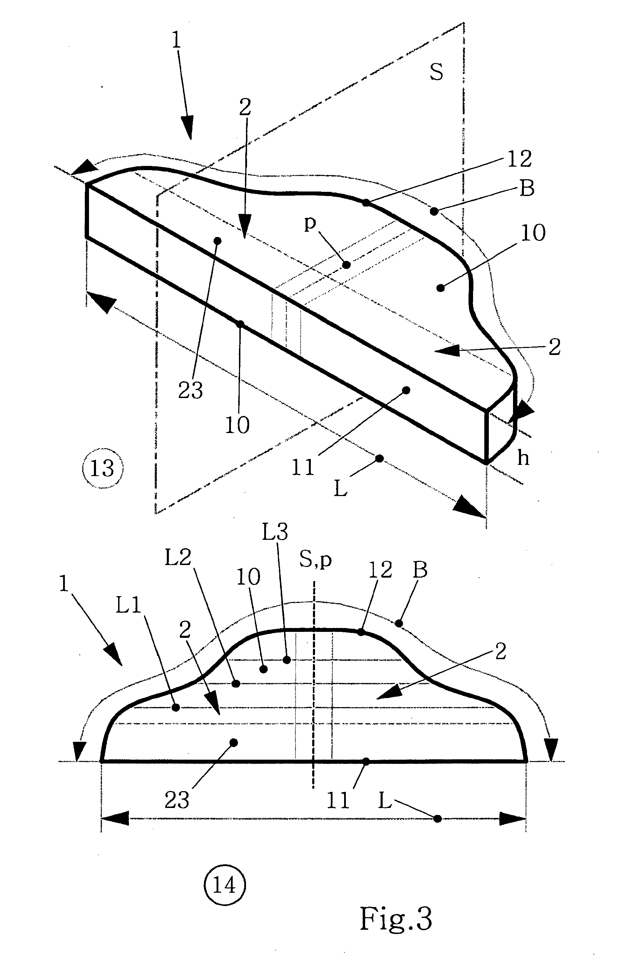

Gemäß der Ausführungsform eines erfindungsgemäßen Aktuators nach Fig. 3 verändert der Aktuator 1 seine Abmessung L in senkrechter Richtung zur Resonanzoberfläche 11 und durchläuft dabei die Werte L1, L2, L3..., wie in Darstellung 14 von Fig. 3 gezeigt. Die Resonanz der im Aktuator 1 erregten Welle erfolgt längs des ersten Seitenflächenbereichs bzw. längs der Resonanzoberfläche mit der Länge L. Diese Resonanz umfasst das Resonanzgebiet 23 des Aktuators 1. Die Resonanzlänge L und das Resonanzgebiet 23 bilden die Hauptresonanzlänge und das Resonanzgebiet des Aktuators 1. Die vorgeschlagene Erfindung sieht eine solche konstruktive Ausführung des Aktuators 1 vor, wo nur eine Resonanzlänge L und ein Resonanzgebiet 23 auftreten. Der Aktuator 1 hat eine Dicke h, die z.B. 5-10 Mal kleiner als die Resonanzlänge L ist. Der Aktuator 1 symmetrisch zur Ebene S, die durch die Mitte der Resonanzoberfläche 11, senkrecht zu ihr und senkrecht zur Hauptfläche 10 verläuft, ausgeführt. In den Darstellungen 13 und 14 von Fig. 3 zeigt die Linie p die Schnittlinie der Ebene S mit dem Aktuator 1.

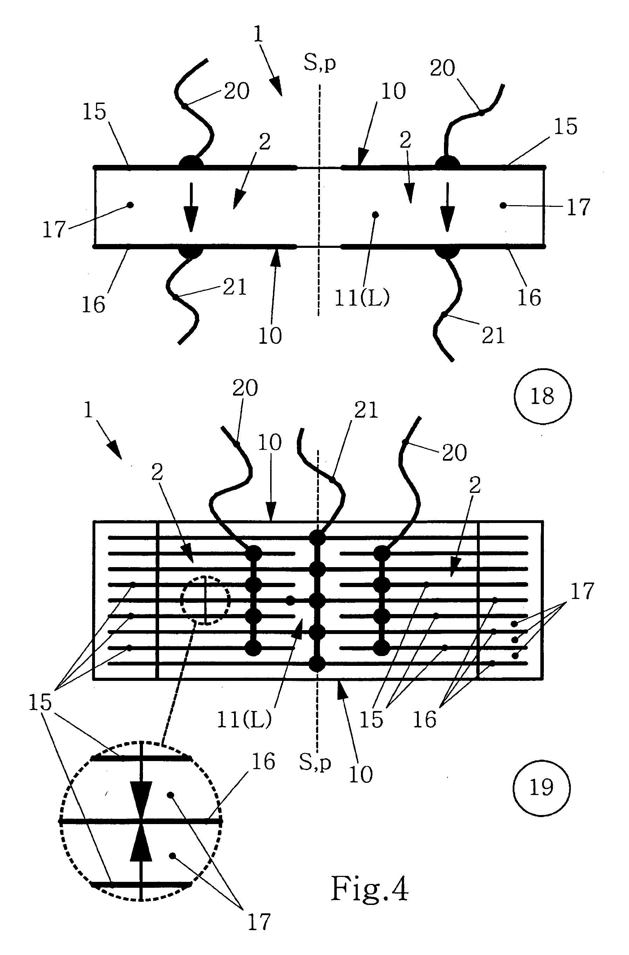

Gemäß Darstellung 18 von Fig. 4 kann jeder der akustischen Stehwellengeneratoren 2 eine Dreischichtstruktur aufweisen, die aus der Schicht der Erregerelektrode 15, der Schicht der allgemeinen Elektrode 16 und der Schicht piezoelektrischer Keramik 17 zwischen ihnen besteht. Genauso gut kann jeder der Stehwellengeneratoren 2 eine Multilayerstruktur aufweisen, bestehend aus einer Vielzahl abwechselnd angeordneter Schichten 15, 16, 17, wie dies in Darstellung 19 der Fig. 4 gezeigt ist. Hierbei können die beiden allgemeinen Elektroden 16 in einer allgemeinen Elektrode zusammengefasst werden. Die Polarisation der piezokeramischen Schicht 17 zwischen den Elektroden 15 und 16 verläuft senkrecht zu diesen Elektroden verlaufen. Die Pfeile in Fig. 4 geben die Polarisationsrichtung an. Die Elektroden 15 und 16 sind über Anschlüsse bzw. Anschlussleitungen 20 und 21 mit einer Erregerspannung bzw. der entsprechenden Elektronik verbunden.

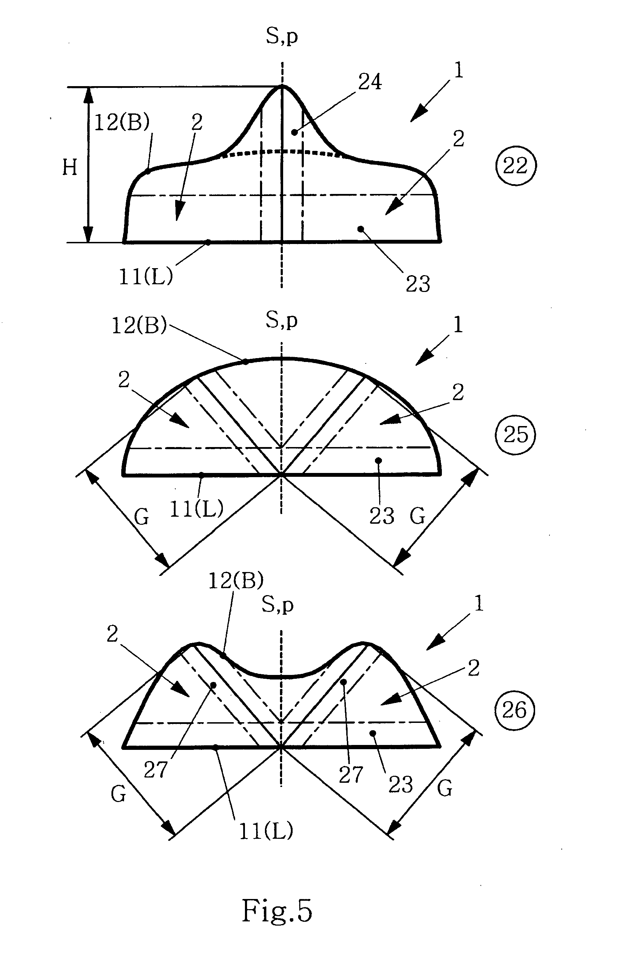

Gemäß Darstellung 22 von Figur 5 kann die Geometrie des Aktuators 1 so beschaffen sein, dass dieser eine zusätzliche Resonanzlänge H aufweist, die gleich der halben Wellenlänge der im Aktuator 1 erregten Welle ist. Im Umfeld der Länge H befindet sich das Resonanzgebiet 24 des Aktuators 1. Die Länge H kann gleich der Höhe des vorspringenden Teils auf dem Aktuator 1 sein. Zudem kann der Aktuator 1 zwei zusätzliche Resonanzlängen G aufweisen (siehe Darstellungen 25 und 26 von Fig. 5). Die Länge G ist hierbei so gewählt, dass sie gleich der halben Wellenlänge der im Aktuator erregten Welle ist. In diesem Fall besitzt der Aktuator 1 zwei zusätzliche Resonanzgebiete 27.

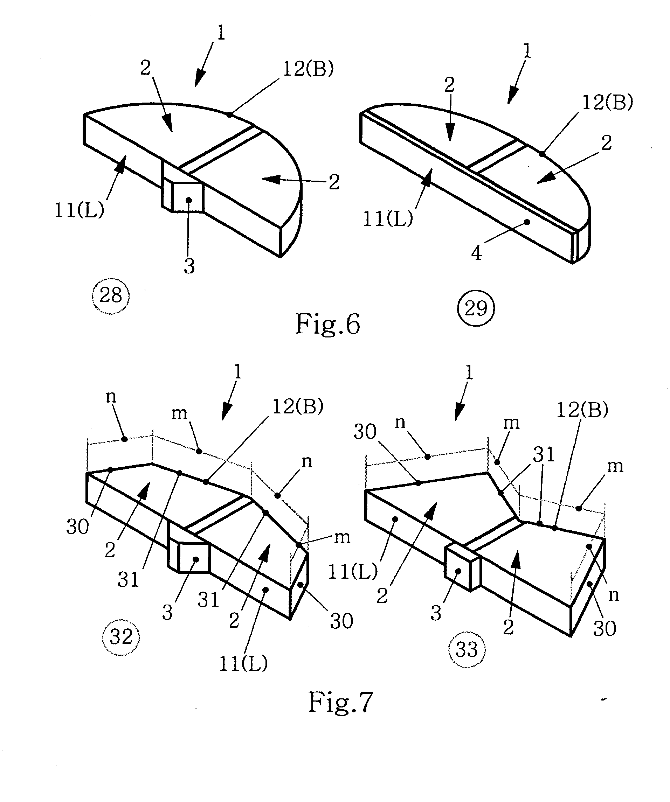

Der zweite Seitenflächenbereich bzw. die Nicht-Resonanzoberfläche 12 des Aktuators 1 kann gemäß Darstellung 28 von Fig. 6 eine Kreis- bzw. Kreisabschnitts-Geometrie aufweisen. Gemäß Darstellung 29 von Fig. 6 kann die Nicht-Resonanzoberfläche 12 auch eine elliptische oder ovale Form haben. Die Resonanzoberfläche 12 kann weitere, nichteckige Formen aufweisen.

Außerdem kann die Nicht-Resonanzoberfläche 12 gemäß den Darstellungen 32 und 33 der Fig. 7 eine mehrflächige (gebrochene) Form haben, die durch mehrere ebene Oberflächen 30, 31 mit ihren jeweiligen Längen n und m gebildet wird. In diesem Fall ergibt sich die Länge B der Nicht-Resonanzoberfläche 12 aus der Summe der Längen n und m aller Oberflächen 30, 31. Dabei gilt, dass die Länge B größer als die Länge der im Aktuator 1 erzeugten akustischen Welle und jeder Länge n und m ungleich der halben Wellenlänge der erregten Welle ist.

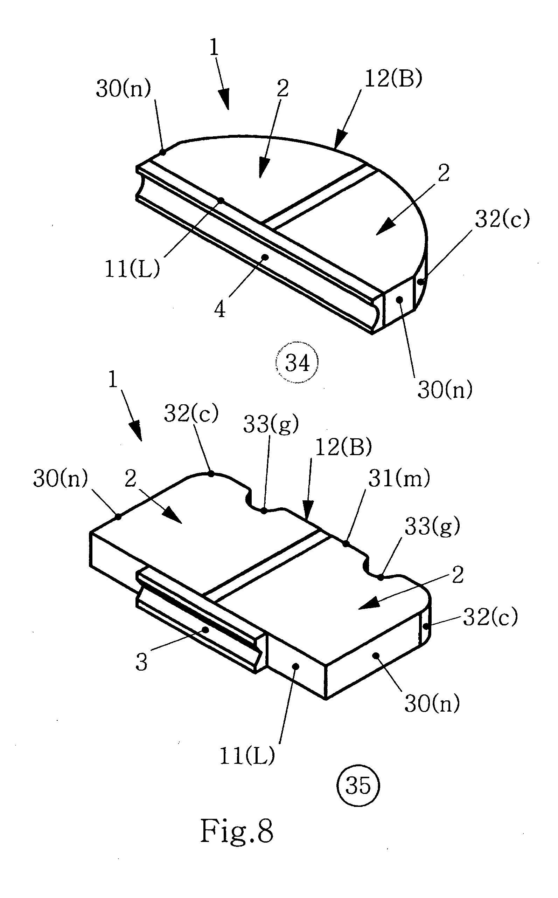

Darüber hinaus kann die Nicht-Resonanzoberfläche 12 eine mehrflächige (gebrochene) Form aufweisen, die aus mehreren ebenen Oberflächen 30, 31 mit ihren Längen n und m in Kombination mit einer oder mehreren zylindrischen, ovalen oder anderen nichteckigen Oberflächen 32, 33 mit ihren Längen c und q, wie in den Darstellungen 34 und 35 von Fig. 8 dargestellt, gebildet werden. Dabei ist die Länge B größer als die Wellenlänge der im Aktuator 1 erzeugten akustischen Welle und jede Länge n, m, c, q ist ungleich der halben Wellenlänge der im Aktuator 1 erzeugten Welle.

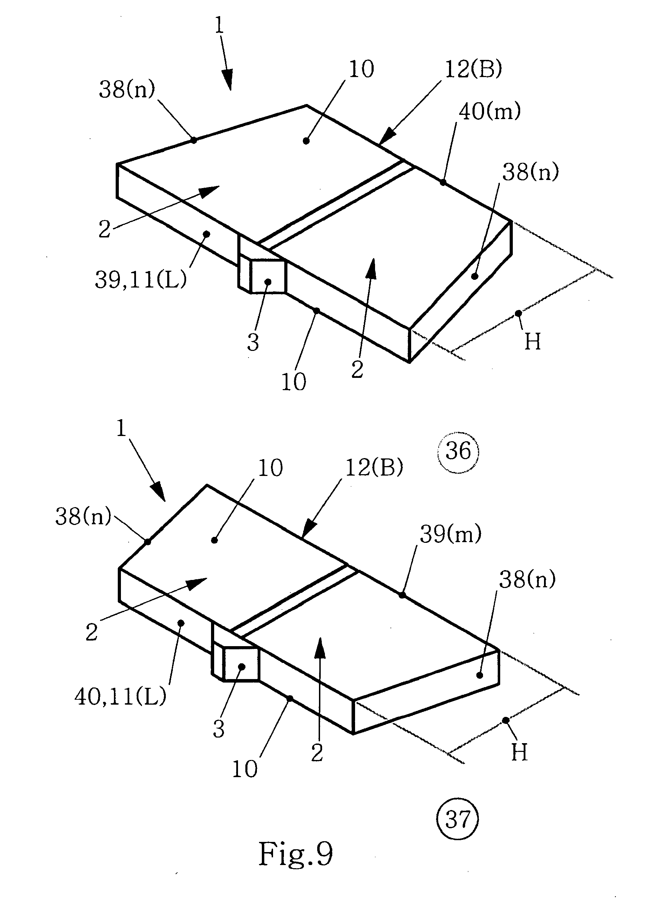

Der erfindungsgemäße Aktuator 1 kann ebenfalls die Form eines gleichschenkligen Trapezes haben, wie in den Darstellungen 36 und 37 der Fig. 9 gezeigt. Ein solcher Aktuator 1 hat zwei Stirnflächen 38, eine lange Seitenfläche 39 und eine kurze Seitenfläche 40. Die Höhe H eines solchen Aktuators ist gleich der halben Wellenlänge der erregten Welle. Es sind zwei Ausführungsvarianten für einen solchen Aktuator 1 denkbar. Im ersten Fall, gemäß Darstellung 36 von Fig. 9, ist die lange Seitenfläche 39 die Resonanzoberfläche, während die Nicht-Resonanzfläche gebildet wird durch beiden Stirnflächen 38 und die kurze Seitenfläche 40. Im zweiten Fall, gemäß Darstellung 37 von Fig. 9, ist die kurze Seitenfläche 40 die Resonanzoberfläche 11. Hier wird die Nicht-Resonanzfläche gebildet durch die beiden Stirnflächen 38 und die lange Seitenfläche 39.

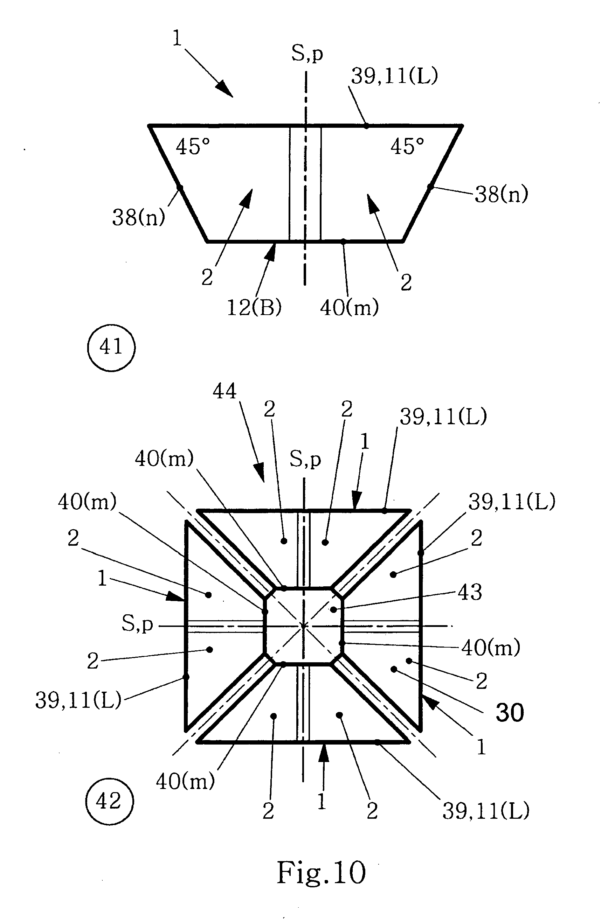

Darstellung 41 von Fig. 10 zeigt in Draufsicht einen trapezförmigen Aktuator 1, bei dem die lange Seitenfläche 39 die Resonanzoberfläche 11 bildet. Gemäß Darstellung 42 von Fig. 10 können beispielsweise vier dieser Aktuator für einen entsprechenden Antrieb bzw. Motor über ein Verbindungselement 43 akustisch miteinander verbunden werden. Hierbei stellen die langen Seitenflächen 39 die Resonanzoberflächen 11 dar. Das Verbindungselement 43 kann aus schallisolierendem Material, z.B. aus einem polymeren Material, gefertigt sein. Das Verbindungselement 43 kann ebenso aus schallleitendem Material wie z.B. Oxid- oder Piezokeramik gefertigt werden. Das Verbinden der Aktuatoren mit dem Verbindungselement 43 kann durch Kleben oder Schweißen auf der Seitenfläche 40 erfolgen. Es ist auch möglich, das Verbindungselement 43 durch Pressen im Zuge der Herstellung der als monolithisches Teil gefertigten Aktuatorvorrichtung 44 herzustellen.

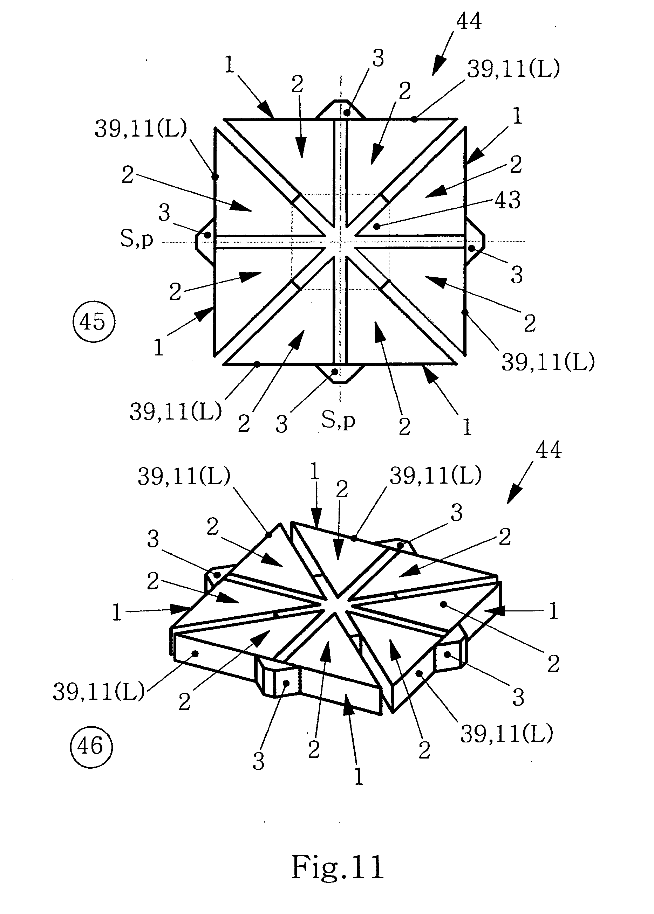

Die Darstellungen 45 und 46 von Fig. 11 zeigt eine Aktuatorvorrichtung 44 mit vier im Wesentlichen dreiecksförmigen Aktuatoren 1, wobei jeder Aktuator 1 ein Friktionselement 3 an der jeweiligen Resonanzoberfläche 11 aufweist. Das Friktionselement 3 ist dabei in der Mitte der Resonanzfläche 11 symmetrisch zur (nicht dargestellten) Symmetrieebene angeordnet.

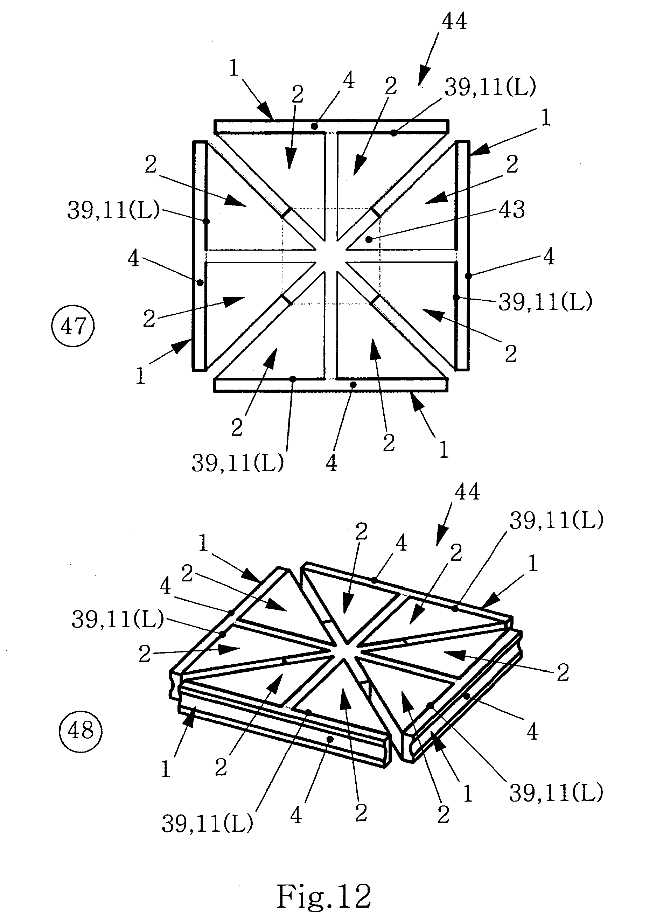

In den Darstellungen 47 und 48 der Fig. 12 ist eine Aktuatorvorrichtung 44 gezeigt, die ebenfalls vier im Wesentlichen dreiecksförmige Aktuatoren 1 aufweist, wobei jeder Aktuator 1 eine Friktionsschicht 4 an der jeweiligen Resonanzoberfläche 11 aufweist. Hierbei erstreckt sich die Friktionsschicht 4 über die gesamte Länge L der Resonanzoberfläche 11.

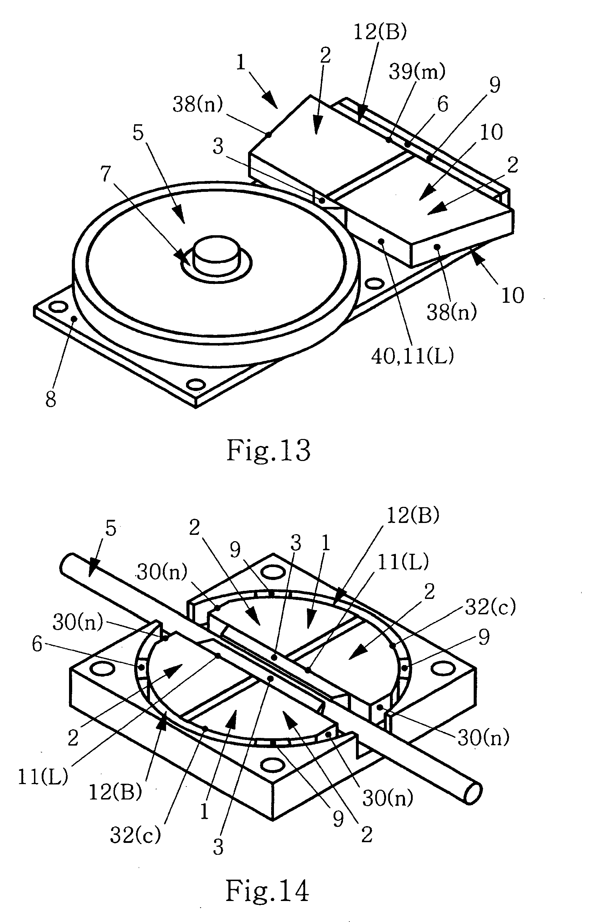

Fig. 13 zeigt einen Motor mit einem erfindungsgemäßen Aktuator 1 in Form eines Trapezes, bei dem die kurze Seitefläche 40 die Resonanzoberfläche 11 bildet. Das anzutreibende Element 5 dieses Motors hat die Form einer Scheibe.

Der in Fig. 14 gezeigte Motor verfügt über zwei gegenüberliegend angeordnete Aktuatoren 1.

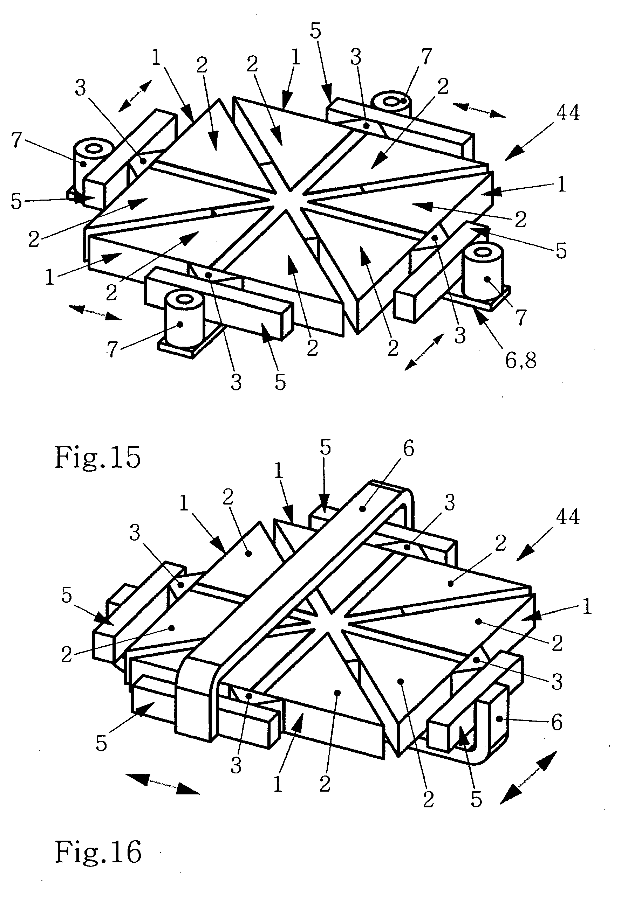

Fig. 15 zeigt einen Motor mit der Aktuatorvorrichtung 44 gemäß Fig. 11, an dessen vier Friktionselemente 3 die vier unabhängigen anzutreibenden Elemente 5 angepresst sind.

Fig. 16 zeigt einen Motor mit der Aktuatorvorrichtung gemäß Fig. 11, bei dem die anzutreibenden Elemente 5 paarweise mittels der U-förmigen Federelemente 6 miteinander verbunden sind.

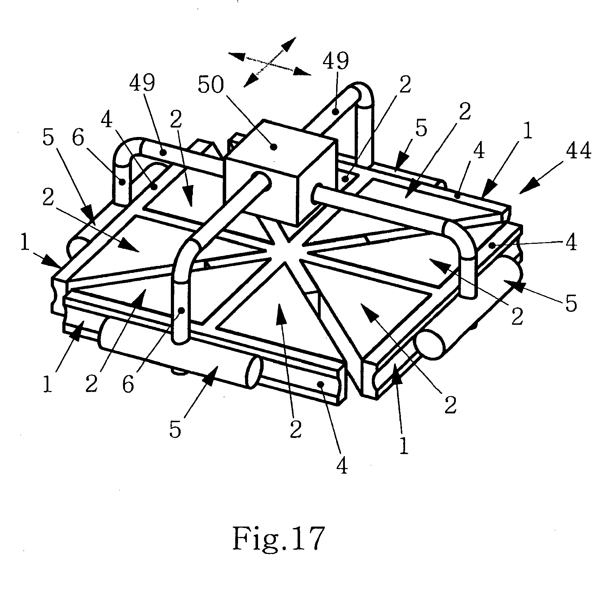

Fig. 17 zeigt einen Motor mit der Aktuatorvorrichtung gemäß Fig. 12, bei dem die U-förmigen Federelemente als Führungsschienen 49 ausgeführt sind, entlang derer sich die Plattform 50 bewegt.

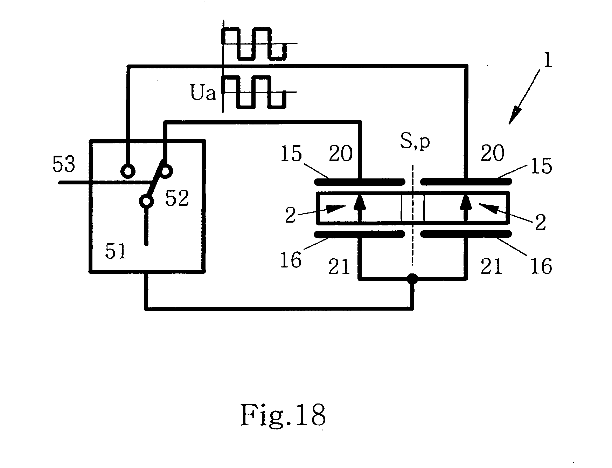

Fig. 18 zeigt ein Blockschaltbild zur Erläuterung der Verbindung der elektrischen Erregervorrichtung 51 mit dem Aktuator 1 eines Motors. Die Erregervorrichtung hat einen Umschalter 52 mit einem oder mehreren Steuereingängen 53, die zur Verbindung mit einem der akustischen Stehwellengeneratoren 2 dienen. Zur Erregung eines der Stehwellengeneratoren 2 des Aktuators 1 erzeugt die elektrische Erregervorrichtung 51 eine Wechselspannung Uₐ, deren Frequenz gleich der Arbeitsfrequenz des Motors Fₐ ist. Diese Spannung kann eine sinusförmige, trapezförmige oder rechteckige Form haben.

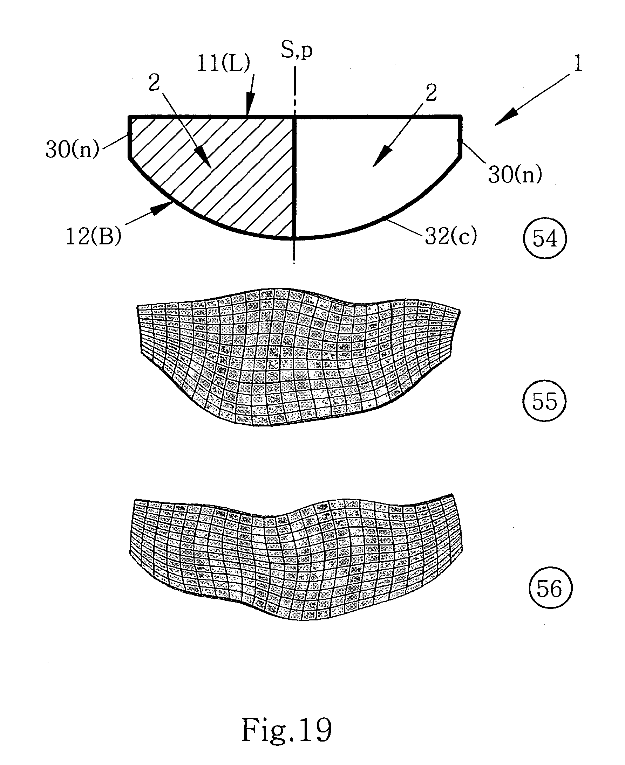

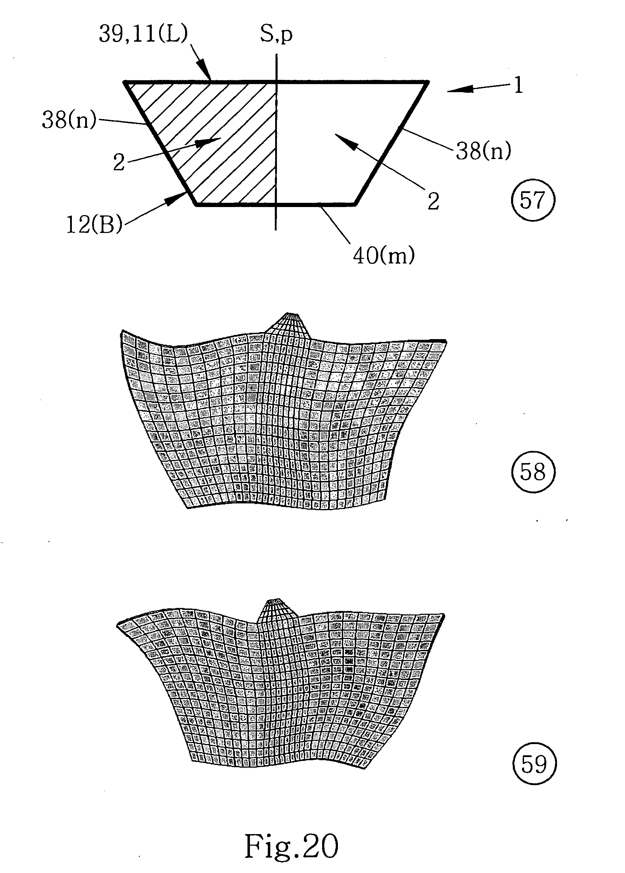

Darstellung 54 von Fig. 19 zeigt schematisch einen Aktuator 1, der in seiner Form dem Aktuator gemäß Darstellung 34 von Fig. 8 entspricht. Die Darstellungen 55 und 56 von Fig. 19 zeigen die Phasen maximaler Deformation des Aktuators bei seiner Erregung durch den Stehwellengenerator 2 (schraffierter Bereich in Darstellung 54). Fig. 20 zeigt in der Darstellung 57 schematisch einen Aktuator 1, der in seiner Form dem Aktuator gemäß Darstellung 36 von Fig. 9 entspricht. Die Darstellungen 58 und 59 von Fig. 20 zeigen die Phasen maximaler Deformation dieses Aktuators 1 bei seiner Erregung durch den Stehwellengenerator 2 (schraffierter Bereich des Aktuators von Darstellung 57).

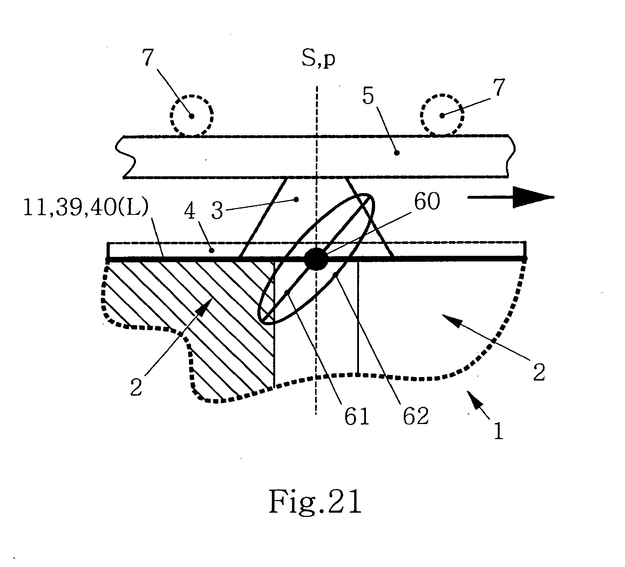

Fig. 21 zeigt einen vergrößerten Ausschnitt eines erfindungsgemäßen Aktuators 1 mit einem Punkt 60 auf der Resonanzoberfläche 11. Bei Erregung des Aktuators 1 mittels eines Stehwellengenerators 2 (schraffierter Bereich) bewegt sich dieser Punkt 60 auf der linearen Bewegungsbahn 61 oder auf einer kreisförmigen oder elliptischen Bewegungsbahn 62.

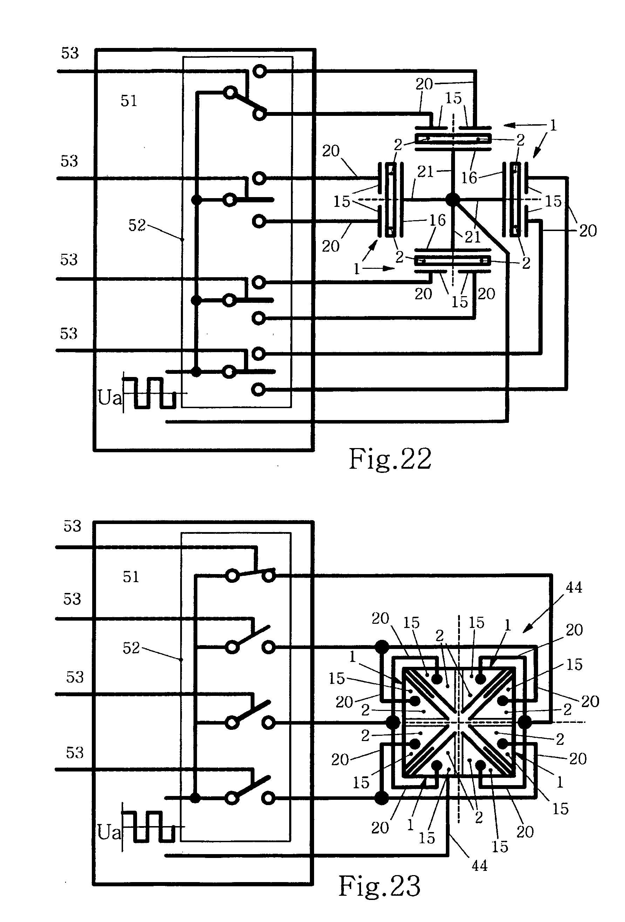

Fig. 22 zeigt anhand eines Blockschaltbilds die Verbindung der elektrischen Erregervorrichtung 51 mit vier kreuzförmig angeordneten Aktuatoren 1, wobei die Aktuatoren 1 akustisch entkoppelt oder lediglich schwach miteinander verbunden sind.

Fig. 23 zeigt anhand eines Blockschaltbilds die Verbindung der elektrischen Erregervorrichtung 51 mit der Aktuatorvorrichtung 44 gemäß Fig. 11, 12, 15, 16, 17, die vier akustisch miteinander verbundene Aktuatoren 1 umfasst.

Die elektrische Erregervorrichtung 51 kann einen Halbbrücken- oder Brückenleistungsverstärker 63 aufweisen, dessen Ausgang oder dessen Ausgänge 64, 65 direkt oder über den Aufspanntransformator 66 mit den akustischen Stehwellengeneratoren 2 des Aktuators 1 verbunden sind.

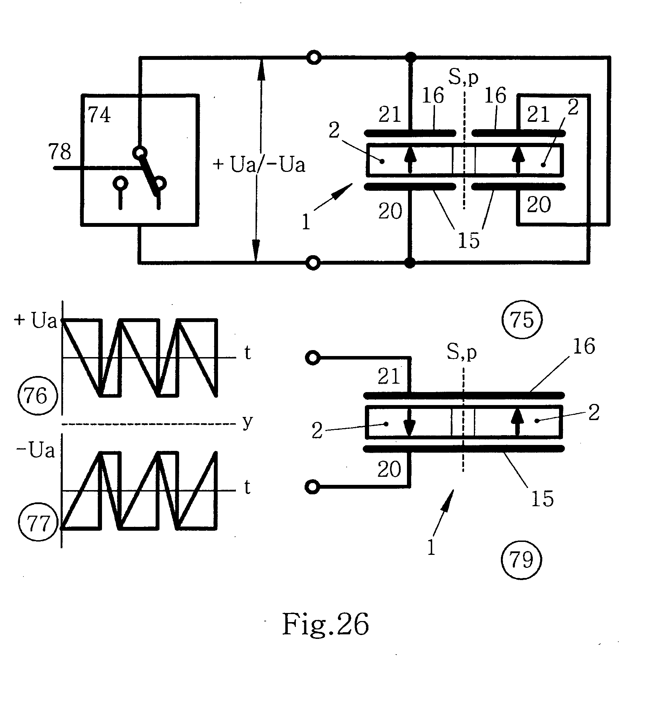

Der Leistungsverstärker 63 kann als Linearverstärker oder als Leistungsschaltverstärker ausgeführt sein. Eingang 67 oder Ausgang 68 des Leistungsverstärkers 63 können mit dem Ausgang oder den Ausgängen 69, 70 des Steuergenerators 71 mit dem Steuereingang 72 verbunden sein. Mit Hilfe des Steuereinganges 72 wird die auf den Ausgang 69 einwirkende Signalfrequenz eingestellt. Der Steuergenerator 71 kann als spannungsgeführter Steuergenerator ausgeführt sein oder kann einen digital geführten Steuergenerator enthalten. Deshalb kann der Steuergenerator 71 mit Hilfe des analogen oder digitalen Signals über den Steuereingang 72 gesteuert werden. Zum Anschluss der Versorgungsspannung E kann der Leistungsverstärker 63 über einen separaten Eingang 73 verfügen. Gemäß Darstellung 75 der Fig. 26 sind die Stehwellengeneratoren 2 des Aktuators 1 gegenphasig verbunden und an die elektrische Erregervorrichtung 74 angeschlossen. In diesem Fall stellt die elektrische Erregervorrichtung 74 eine nichtsymmetrische elektrische Spannung +Uₐ oder -Uₐ bereit, die eine recheckige, zähneförmige oder eine andere als in den Darstellungen 76 und 77 der Fig. 26 dargestellte Form aufweisen kann.

Eine solche elektrische Erregervorrichtung 74 besitzt einen Steuereingang 78, mit dem spiegelbildlich die Form der Spannung, bezogen auf die Linie y, parallel zur Zeitachse t, geändert werden kann. Die Frequenz der Spannung +Uₐ oder -Uₐ ist gleich der Frequenz Fₐ.

Die gegenphasige Verbindung der Stehwellengeneratoren 2 erfolgt durch Verbinden der Elektroden 15 und 16 über Kreuz oder durch unterschiedlich gerichtete Polarisation der Piezokeramik, wie in Darstellung 79 der Fig. 26. gezeigt.

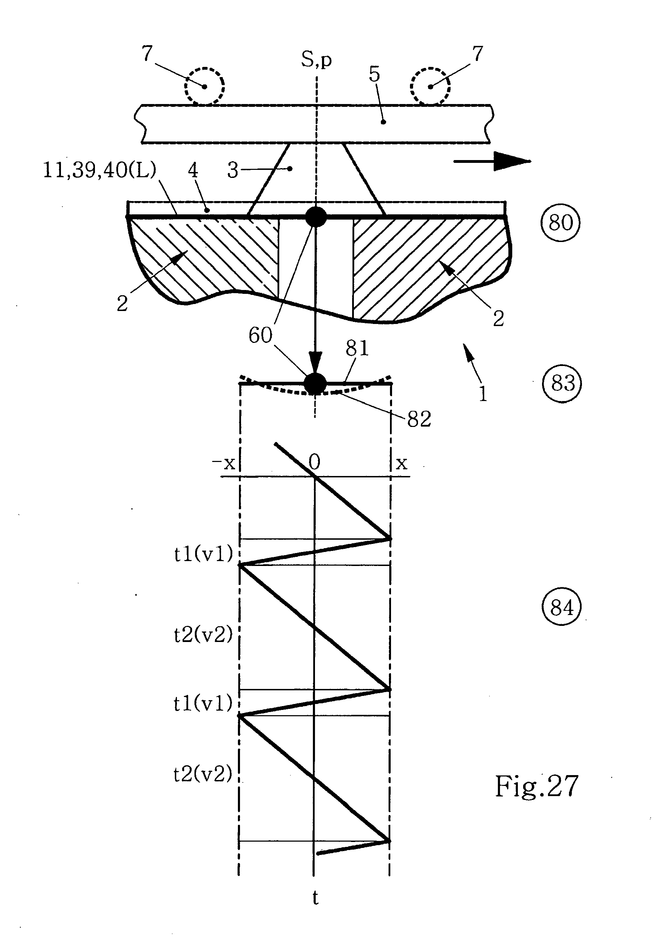

Darstellung 80 von Fig. 27 zeigt das Mittelteil eines erfindungsgemäßen Aktuators 1 mit dem Materialpunkt 60 auf der Resonanzoberfläche 11. Bei Ansteuerung des Aktuators 1 mit Hilfe der beiden gegenphasig geschalteten Stehwellengeneratoren 2 bewegt sich dieser Punkt auf einer linearen Bewegungsbahn 81 oder auf einer leicht gekrümmten Bewegungsbahn 82, von -x bis x, wie in Darstellung 83 gezeigt. Die Bewegungsbahnen verlaufen symmetrisch zur Ebene S und der Linie p.

Darstellung 84 von Fig. 27 zeigt den zeitlichen Verlauf der Bewegung des Materialpunktes 60. Hieraus folgt, dass bei der Bewegung in einer Richtung der Materialpunkt 60 den Abstand 2x in der Zeit t1 und bei Bewegung in der anderen Richtung in der Zeit t2 durchläuft. D.h. der Materialpunkt 60 bewegt sich bei einer Bewegung in der einen und anderen Richtung unterschiedlich schnell (v1 und v2).

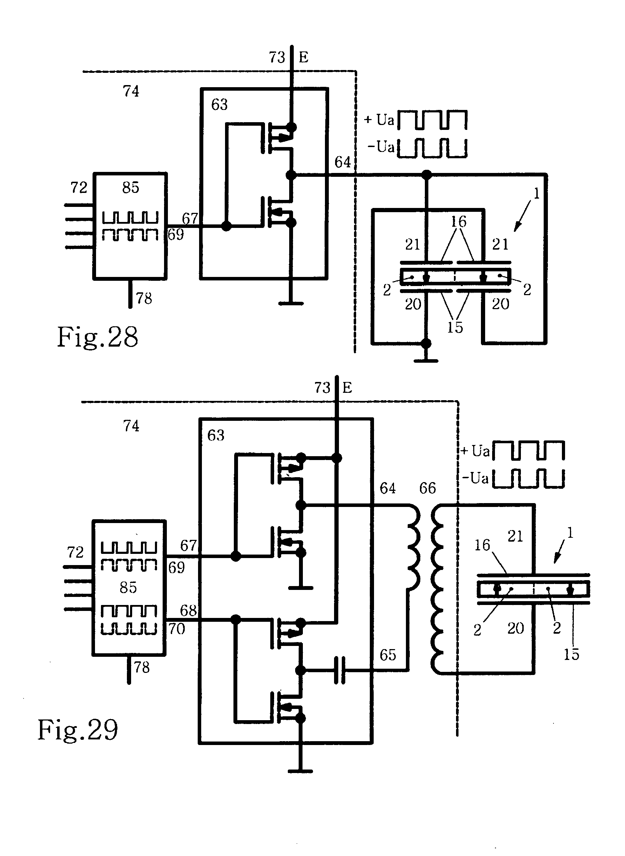

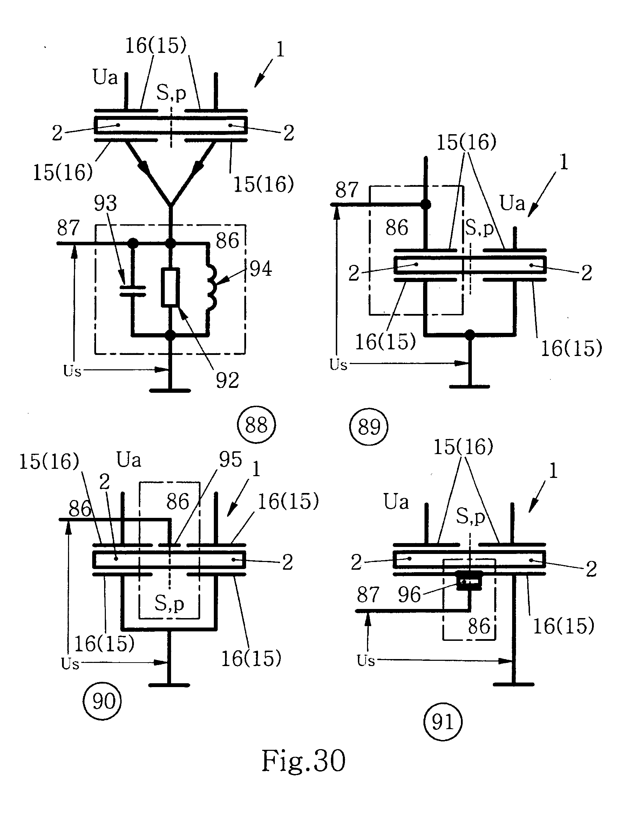

Gemäß Fig. 28 und Fig. 29 umfasst die elektrische Erregervorrichtung 74 den Generator 85, der eine nichtsymmetrische Spannung bereitstellt, deren Form spiegelbildlich mit Hilfe des Steuereinganges 78 geändert werden kann und bei dem die Frequenz mit dem Steuereingang 72 eingestellt werden kann. Der Generator 85 kann als spannungsgeführter Generator ausgeführt werden oder kann einen digital geführten Steuergenerator enthalten. Deshalb kann der Steuergenerator 85 mit Hilfe des analogen oder digitalen Signals über den Steuereingang 72 gesteuert werden. Gemäß den Darstellungen 88 bis 91 von Fig. 30 kann der Aktuator 1 ein Rückkopplungselement 86 haben, das einen Ausgang 87 hat. Am Ausgang 87 wird eine Signalspannung des Rückkopplungselementes Uₛ bereitgestellt. Nach Darstellung 88 der Fig. 30 kann das Rückkopplungselement 86 kann aus dem in Reihe mit dem Stehwellengenerator 2 geschalteten Aktuator 1 bestehen. In dem Fall stellt der Widerstand 92, der Kondensator 93 oder die Induktivitätsspule 94 das Rückkopplungselement dar. Diese Bauteile können einzeln, paarweise oder in einer beliebigen anderen Kombination geschaltet werden.

Als Rückkopplungselement kann gemäß Darstellung 89 von Fig. 30 auch die Elektrode 15 oder 16 des Aktuators 1 dienen.

Außerdem kann sich gemäß Darstellung 90 von Fig. 30 auf dem Aktuator 1 eine als Rückkopplungselement 86 ausgeführte zusätzliche Hilfselektrode 95 befinden.

In einer weiteren Ausführungsvariante nach Darstellung 91 von Fig. 30 kann sich auf dem Aktuator 1 ein als Rückkopplungselement 86 ausgeführtes Hilfspiezoelement 96 sich befinden.

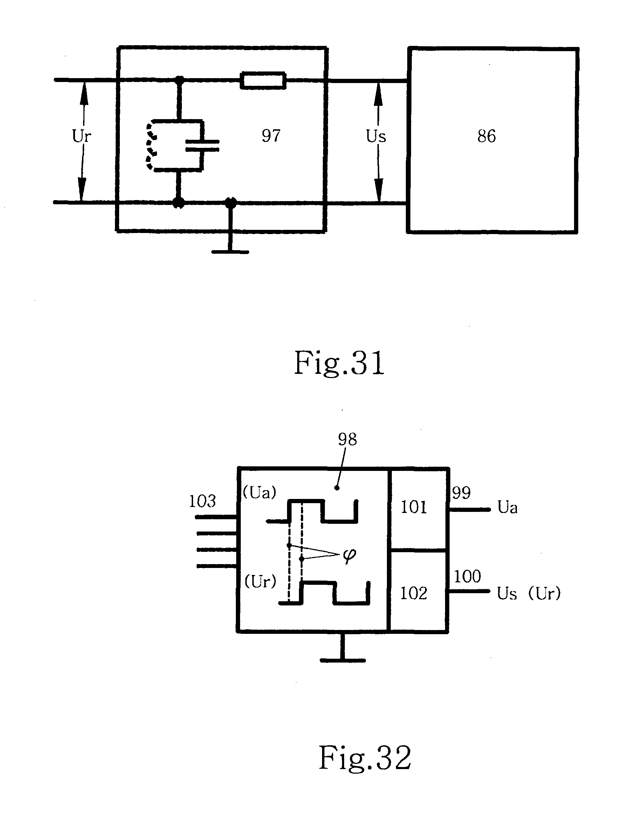

Nach Fig. 31 kann In der Erregervorrichtung 51, 74 das Rückkopplungselement 86 mit dem Filter der ersten Harmonischen 97 seiner Ausgangsspannung Us verbunden sein. Das Filter 97 kann ein einfaches LC-Bandfilter darstellen, es kann als aktives Filter für tiefe Frequenzen oder als aktives Bandfilter ausgeführt sein. Das Filter 97 kann auch ein Digitalfilter sein. Aufgabe des Filters 97 ist es, die erste Harmonische der Spannung Uₛ des Rückkopplungselementes herauszufiltern. Am Ausgang des Filters 97 erscheint die sinusförmige Spannung Uᵣ.

Außerdem kann die elektrische Erregervorrichtung 51, 74 einen Phasendetektor 98 beinhalten (siehe Fig. 32), der über einen Stützeingang 99 und einen Messeingang 100 verfügt. An den Stützeingang 99 wird die Erregerspannung Uₐ, die den Stehwellengenerator 2 des Aktuators 1 anregende Spannung oder eine mit dieser Spannung in der Phase zusammenfallende Spannung angelegt. An den Messeingang 100 wird die Spannung Uₛ oder Uᵣ angelegt. Der Phasendetektor 98 kann aus den Komparatoren 101 und 102 bestehen, die die Spannungsflanken Uₐ und Uᵣ formieren. An seinem Ausgang erzeugt der Phasendetektor 98 ein analoges oder ein diskretes Signal, das die Angaben zum Winkel der Phasenverschiebung ϕ zwischen den Spannungen Uₐ und Ur enthält.

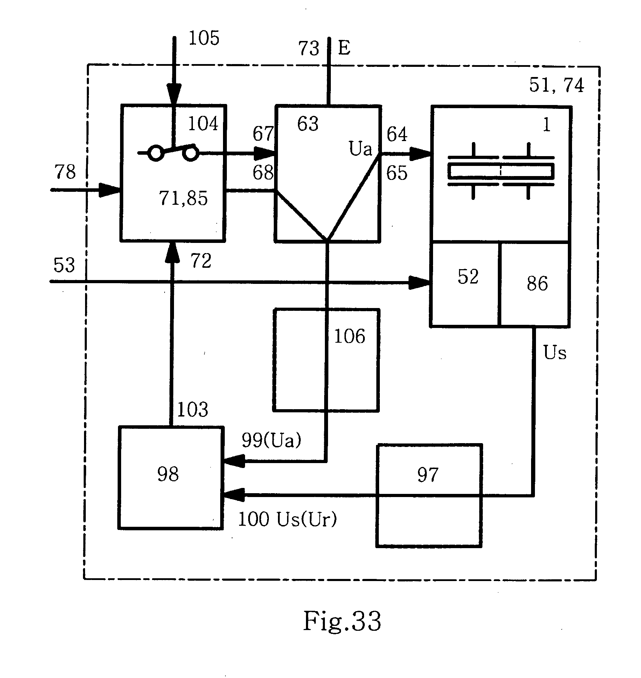

Fig. 33 zeigt das Blockschaltbild einer Erregervorrichtung für den einen Motor mit dem erfindungsgemäßen Aktuator 1. Die elektrische Erregervorrichtung 51, 74 kann den Ausschalter 104 mit seinem Steuereingang 105 enthalten, der zum Start und Stopp des Motors dient. Außerdem kann die elektrische Erregervorrichtung 51, 74 das Filter 106 der ersten Harmonischen der Spannung Uₐ enthalten, analog zum Filter 97.

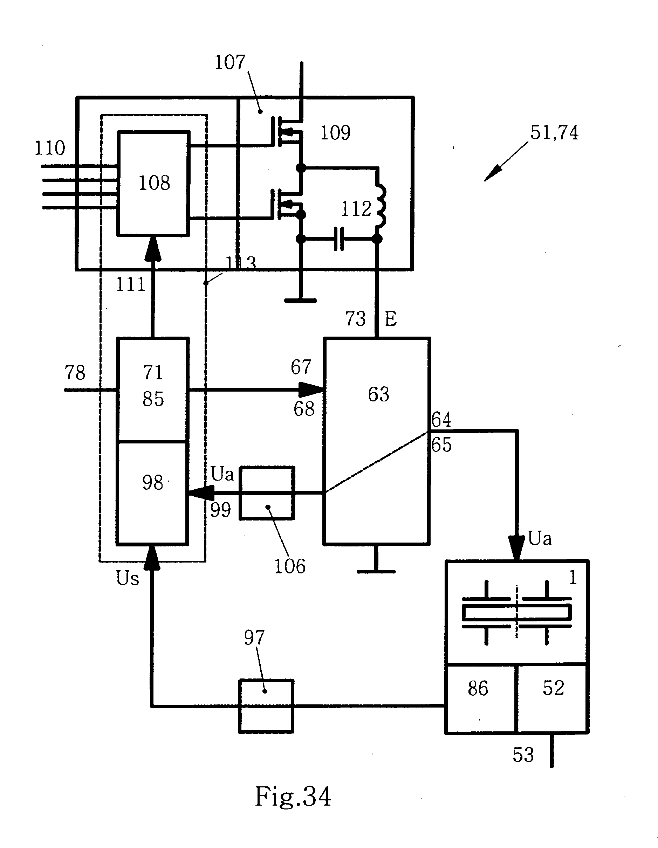

Nach Fig. 34 kann die elektrische Erregervorrichtung 51, 74 einen Controller 107 für die Spannung E des Leistungsverstärkers 63 enthalten. Ein solcher Controller kann aus dem PWM-Modulator 108 mit dem Leistungsverstärker 109 bestehen. Der Modulator 108 kann über einen analogen oder digitalen Steuereingang 110 und einen Synchronisationseingang 111 verfügen. Mit dem Steuereingang 110 wird die Breite der PWM-Impulse geändert. Der Leistungsverstärker 109 enthält das Filter 112.

Die Filter der ersten Harmonischen 97 und 106, der Phasendetektor 98, der Steuergenerator 71, 75 und der PWM-Modulator 108 können mittels entsprechender Programmierung der digitalen Recheneinheit 113 realisiert werden, die einen integrierten Mikroprozessorschaltkreis DSP oder FPGA sein kann.

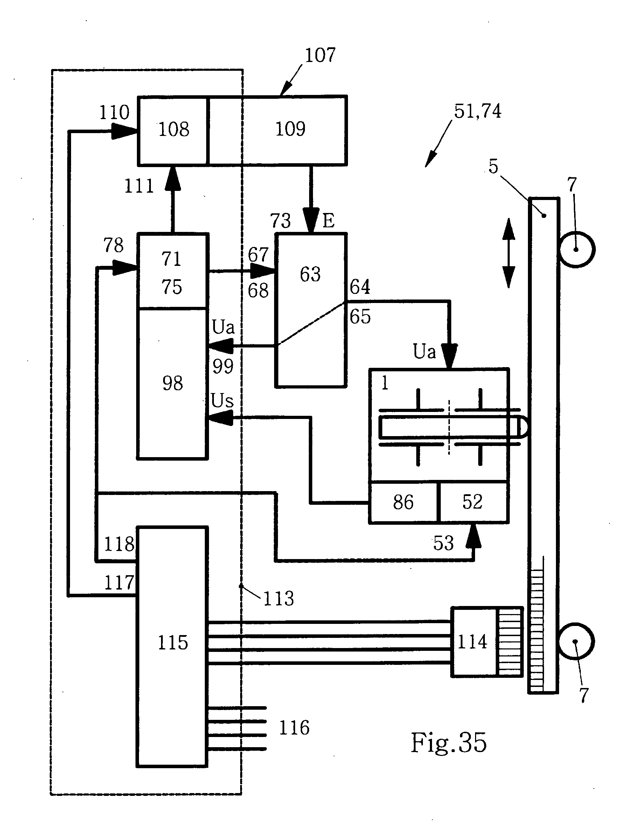

Das anzutreibende Element eines Motors mit dem erfindungsgemäßen Aktuator kann gemäß Fig. 35 mit einem Lage- oder Geschwindigkeitsgeber 114 ausgestattet sein, und die elektrische Erregervorrichtung 51, 74 kann einen Controller 115 für die Lage oder die Geschwindigkeit des anzutreibenden Elements 5 enthalten. Der Controller 115 kann einen Führungseingang 116, einen Ausgang 117 zur Steuerung der Bewegungsrichtung und einen Ausgang 118 zur Steuerung der Bewegungsgeschwindigkeit für das anzutreibende Element 5 aufweisen. In anderen Ausführungsvarianten können die Ausgänge 117 und 118 miteinander verbunden sein. Der Controller 115 kann als separate digitale Rechnerbaugruppe, z.B. als DSP oder FPGA, ausgeführt sein. Außerdem kann der Controller 116 eine digitale Recheneinheit 113 sein.

Die Ansteuerung des erfindungsgemäßen Aktuators kann prinzipiell auf zwei Arten erfolgen:
Gemäß einem ersten Funktionsprinzip wird von der elektrischen Erregervorrichtung 51 an die Schicht der Erregerelektrode 15 und an die Schicht der allgemeinen Elektrode 16 eines der akustischen Stehwellengeneratoren 2 eine Erregerwechselspannung Uₐ angelegt. Aufgrund des umgekehrten piezoelektrischen Effektes bewirkt das sich zwischen den Elektroden 15 und 16 ausbildende elektrische Feld durch seine Einwirkung auf die piezoelektrische Keramikschicht 17 eine Deformation des Aktuators 1. Die Größe der Deformationsamplitude wird durch die elektrische Feldstärke bestimmt, die wiederum von der Höhe der elektrischen Spannung Uₐ und der Dicke der piezoelektrischen Keramikschicht 17 abhängt.

Bei Bedarf kann die Höhe der elektrischen Spannung Uₐ durch Aufteilung der Stehwellengeneratoren 2 in Sektionen, d.h. im mehrere Schichten (d.h. Multilayeraufbau) verringert werden.

Die Frequenz Fₐ der Erregerspannung Uₐ wird so gewählt, dass sie gleich der Frequenz Fₒ ist, die der Resonanzfrequenz der zweiten Mode der Longitudinalschwingungen der Resonanzoberfläche 11 entspricht, bzw. die Frequenz kann sich nah zu dieser Frequenz befinden. Bei der Frequenz Fₒ (Fₐ) breitet sich eine akustische Welle aus, deren Länge gleich L längs zur Resonanzoberfläche 11 des Aktuators 1 ist.

Da die Resonanzoberfläche 12 für diese Frequenz keine Resonanzoberfläche darstellt (ihre Länge B ist kein Vielfaches der halben Wellenlänge der im Aktuator 1 erzeugten Welle), breitet sich auch keine akustische Welle längs dieser Oberfläche aus.

Das bedeutet, dass die sich auf der Resonanzoberfläche 11 befindenden Materialpunkte des Aktuators 1 eine größere mittlere Amplitude aufweisen, als die auf der Nicht-Resonanzoberfläche 12 liegenden Materialpunkte. Deshalb kann auf dem Aktuator 1 quasi ein Resonanzgebiet 23 ausgewiesen werden, in dem Resonanzschwingungen des Aktuators 1 entstehen. Außerhalb dieses Resonanzgebietes 23 befindet sich ein Nicht-Resonanzgebiet für den Aktuator 1.

Die Frequenz Fₒ kann näherungsweise nach der Formel Fₒ=N/L bestimmt werden, wo N die Frequenzkonstante ist, die ein gering vom Typ der Piezokeramik und der Form des Aktuators 1 abhängt. Für den in Darstellung 34 der Fig. 8 gezeigten Aktuator aus Piezokeramik PIC 181 der Firma PI Ceramic mit L=50 mm, n= 8mm, c=60 mm, h=10 mm beträgt N=4694,9 kHz mm.

Der erfindungsgemäße Aktuator 1 ist symmetrisch zur Symmetrieebene S (p) ausgeführt und der akustische Stehwellengenerator 2 ist symmetrisch zu dieser Ebene S und zu beiden Seiten dieser Ebene angeordnet.

Da im betrachteten Fall die elektrische Erregerspannung Uₐ nur an einen der Stehwellengeneratoren 2 angelegt wird, deformiert auch nur dieser Stehwellengenerator 2 den Aktuator 1, und zwar an dieser Stelle. Durch diese Deformation wird im Aktuator 1 eine akustische Well erzeugt. Der Aktuator 1 wirkt der Ausbreitung der akustischen Welle an der Stelle entgegen, an der sich der Stehwellengenerator 2 befindet und an den die elektrische Erregerspannung Uₐ nicht anliegt wird.

Dadurch bildet sich im Aktuator 1 eine asymmetrische Stehwelle aus. Infolge der Ausbreitung der asymmetrischen Welle bewegen sich die auf der Resonanzoberfläche 11 in seinem zentralen Teil liegenden Materialpunkte des Aktuators 1 auf geneigten linearen Bewegungsbahnen 61 oder auf elliptischen Bewegungsbahnen 62 (dargestellt in Fig. 21 für den Materialpunkt 60). Der Neigungswinkel der Bewegungsbahn 61 und 62 zur Resonanzoberfläche 11 hängt von der Form des Aktuators 1 ab. Die Fig. 21 zeigt eine akustische Welle, bei der zur Resonanzoberfläche 11 geneigte Bewegungsbahnen 61, 62 entstehen und die als rechtsgeneigte Welle bezeichnet werden können.

Der erfindungsgemäße Aktuator 1 kann eine zusätzliche Resonanzlänge H oder zwei zusätzliche Resonanzlängen G aufweisen (Darstellungen 22, 25 und 26 von Fig. 5), die seitlich zur Mitte der Resonanzoberfläche 11 angeordnet sind. Die Darstellungen 55 und 56 von Fig. 19 zeigen die Deformation eines Aktuators 1, bei dem eine zusätzliche Resonanz - bezogen auf die Länge G - auftritt. Die Erregung dieser zusätzlichen Resonanz zusammen mit der Grundresonanz ermöglicht es, die elliptische Bewegungsbahn 62 gemäß Fig. 21 so zu variieren, dass sie breiter wird.

Das Friktionselement 3 oder die Friktionsschicht 4 sind auf der Resonanzoberfläche 11 symmetrisch zur Symmetrieebene S (p) angeordnet; deshalb bewegen sich die Materialpunkte des Friktionselementes 3 oder der Friktionsschicht 4 auf vergleichbaren Bewegungsbahnen 61 und 62.

Die Bewegung des Friktionselementes 3 oder der Friktionsschicht 4 auf geneigten Bewegungsbahnen 61 oder auf elliptischen Bewegungsbahnen 62 bewirkt eine in Fig. 21 mit Pfeil angegebene Bewegung des anzutreibenden Elementes 5.

Durch Umschalten des Umschalters 52 der Stehwellengeneratoren 2 ist es möglich, im Aktuator 1 eine rechtsgeneigte (Fig. 20, 21) oder eine linksgeneigte (nicht abgebildete) Stehwelle zu erzeugen. Dadurch kann die Bewegungsrichtung des anzutreibenden Elementes 5 umgekehrt werden.

Gemäß einem zweiten Funktionsprinzip sind beide Stehwellengeneratoren 2 in Phase geschaltet. Dabei wird an beide Stehwellengeneratoren 2 die von der elektrischen Erregervorrichtung 74 bereitgestellte asymmetrische elektrische Spannung +Uₐ (oder -Uₐ) angelegt (Darstellungen 75 bis 77 von Fig. 26). Die Frequenz der Spannung Uₐ wird so gewählt, dass sie gleich der Frequenz Fₒ ist, die der Resonanzfrequenz der zweiten Mode der Longitudinalwellen längs der Resonanzoberfläche 11 entspricht. Durch die Einwirkung dieser Spannung bewegt sich der Materialpunkt 60 (Darstellungen 80 und 83 von Fig. 27) auf der linearen Bewegungsbahn 81 oder auf der leicht gekrümmten Bewegungsbahn 82.

Das Einwirken der asymmetrischen elektrischen Spannung auf den Aktuator 1, bei dem die Stehwellengeneratoren 2 gegenphasig geschaltet sind und der die sich ändernde Länge L, L1, L2, L3 (siehe Fig. 3) aufweist, führt zu einer zeitlich bezogenen nichtsymmetrischen Bewegung des Materialpunktes 60. Diese Nichtsymmetrie drückt sich dadurch aus, dass sich der Materialpunkt 60 in der ersten Hälfte der Periode (t1, v1) schneller als in der zweiten Hälfte der Periode (t2, v2) bewegt und zwar so, wie in Darstellung 84 der Fig. 27 gezeigt. Gleichermaßen bewegt sich auch das Friktionselement 3 des Aktuators 1.

Die zeitlich bezogene nichtsymmetrische Bewegung des Materialpunktes 60 kann dadurch erklärt werden, dass für die Mehrzahl der Harmonischen der Erregerspannung +Uₐ (oder -Uₐ) die Längen (L1, L2, L3) die Resonanzlängen darstellen.

Aufgrund der Nichtlinearität des Friktionskontaktes zwischen dem Friktionselement 3 und dem anzutreibenden Element 5 entsteht eine Bewegungskraft, die das anzutreibende Element 5 in die Richtung stößt, die in Fig. 27 mittels Pfeil angegeben ist.

Die Änderung der Spannungsform +Uₐ mittels Umschalter 78 in ihr Spiegelbild -Uₐ (Darstellungen 75 bis 77 von Fig. 26) hat eine Änderung der Wirkungsrichtung der Kraft zur Folge, d.h.sie bewirkt eine Änderung Bewegungsrichtung des anzutreibenden Elements 5.

Beide zuvor beschriebenen Funktionsprinzipien gelten zumindest für die in den Figuren 6 bis 10 gezeigten von Aktuatorentypen.

Der erfindungsgemäße Aktuator kann in Motoren Verwendung finden, bei denen das oder die anzutreibende/anzutreibenden Element/Elemente 5 eine Längsbewegung oder eine Drehbewegung ausführen.

Wenn der Aktuator 1 als gleichschenkliges Trapez ausgeführt ist, bei dem die lange Seitenfläche 39 (siehe Darstellung 36 von Fig. 9 bzw. Darstellung 57 von Fig. 19) die Resonanzoberfläche 11 mit der Länge L bildet, schwingt der Aktuator 1 in der in den Darstellungen. 58 und 59 von Fig. 20 dargestellten Art. In diesem Fall kann der Winkel zwischen der Seitenfläche 39 und der Stirnfläche 38 zu 45° gewählt werden (siehe Darstellung 41 von Fig. 10).

Ein Motor kann beispielsweise vier erfindungsgemäße Aktuatoren 1 aufweisen, die so angeordnet sind, dass sie ein Malteserkreuz bilden (Darstellung 42 von Fig.10). In diesem Fall können die Aktuatoren 1 akustisch entkoppelt sein.

Außerdem können die Aktuatoren untereinander akustisch mit Hilfe des Verbindungselements 43, das ein schallleitendes Material aufweist bzw. aus diesem besteht, miteinander gekoppelt sein. In diesem Fall bilden alle vier Aktuatoren 1 eine akustisch verbundene Aktuatorvorrichtung 44, die wie ein monolithischer Aktuator schwingt (siehe Darstellung 42 von Fig. 10).

Besagte Aktuatorvorrichtung 44 kann auf jeder ihrer Seitenflächen 39 ein Friktionselement 3 (siehe Darstellungen 45 und 46 von Fig. 11) aufweisen.

Ein Motor mit einer solchen Aktuatorvorrichtung 44 kann unabhängige anzutreibende Elemente 5 (siehe Fig. 15) oder paarweise verbundene anzutreibende Elemente 5 (siehe Fig. 16) aufweisen.

Die Stehwellengeneratoren 2 der Aktuatorvorrichtung 44 eines Motors mit unabhängigen anzutreibenden Elementen 5 können gemäß Fig. 22 mit der Erregervorrichtung 5 verbunden sein.

Außerdem kann die Aktuatorvorrichtung 44 auf ihren Seitenflächen 39 die Friktionsschichten 4 aufweisen (siehe Darstellungen 47 und 48 von Fig. 12).

Ein Motor mit einer solchen Aktuatorvorrichtung 44 kann paarweise miteinander verbundene anzutreibende Elemente 5 enthalten, die die Plattform 50 in Bewegung versetzen. Ein solcher Motor ermöglicht eine Zweikoordinatenverschiebung der Plattform 50, wie in Fig. 17 mit Pfeilen dargestellt.

Die Stehwellengeneratoren 2 der Aktuatorvorrichtung 44 des Motors mit paarweise verbundenen anzutreibenden Elementen 5 gemäß Fig. 16 und Fig. 17 können mit der Erregervorrichtung 51 in der in Fig. 23 gezeigten Weise verbunden sein.

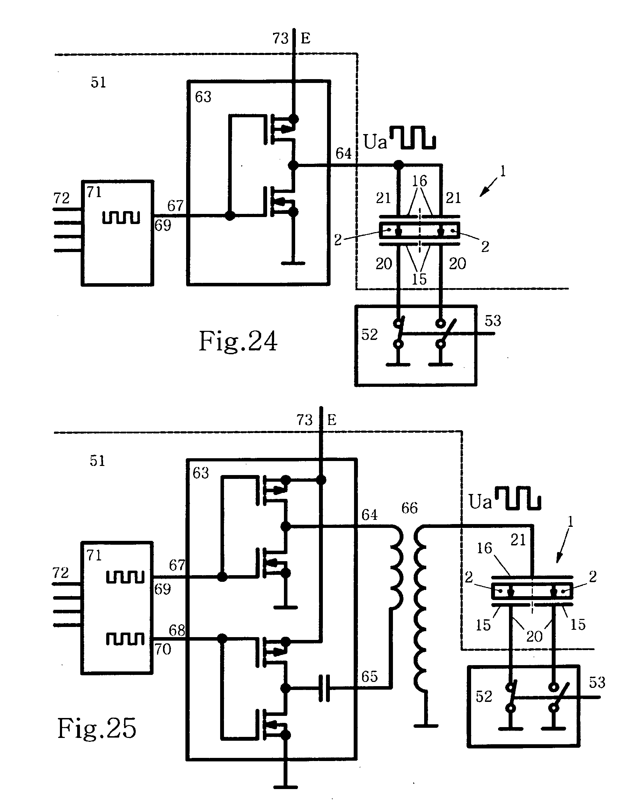

In der elektrischen Erregervorrichtung 51, 74 kann ein Halbbrückenleistungsverstärker 63 verwendet werden (siehe Fig. 24, 25, 28, 29).

Der Ausgang 64, 65 des Leistungsverstärkers 63 kann direkt oder über den Aufspanntransformator 66 mit dem akustischen Stehwellengenerator 2 des Aktuators 1 verbunden sein. Die vom Leistungsverstärker 63 bereitgestellte elektrische Erregerspannung Uₐ kann eine sinusförmige, trapezförmige oder rechteckige Form haben.

Die Form der elektrischen Erregerspannung Uₐ wird durch den Generator 71, 85 vorgegeben. Die Frequenz Fₐ dieser Spannung kann über ein auf den Steuereingang 72 gelegtes analoges oder digitales Signal geregelt werden.

Die Spannung Uₐ kann direkt, wie in Fig. 24, 25, 28, 29 dargestellt, an die Elektrode 15, 16 des Stehwellengenerators 2 des Aktuators 1 angelegt werden.

Es besteht die Möglichkeit, dass die elektrische Erregervorrichtung 51, 74 ein Rückkopplungselement 86 enthält. Am Ausgang 87 des Rückkopplungselementes 86 wird eine elektrische Spannung bereitgestellt Uₛ, deren Phase der ersten Harmonischen - bezogen zur Phase der Spannung Uₐ - die Lage der Frequenz Fₒ widerspiegelt.

Da in der Praxis die Spannung Uₛ nicht immer eine sinusförmige Form hat, kann die elektrische Erregervorrichtung 51, 74 ein Filter für die erste Harmonische 97 enthalten, welches mit dem Ausgang des Rückkopplungselementes 86 verbunden ist. An den Eingang des Filters 97 wird die nichtsinusförmige Spannung Uₛ angelegt und an seinen Ausgang erscheint eine sinusförmige Spannung mit der gleichen Frequenz wie die Spannung Uₛ.

Zur Bestimmung des Phasenunterschiedes zwischen den Spannungen Uₐ und Uₛ kann die elektrische Erregervorrichtung einen Phasendetektor 98 (siehe Fig. 32, 33) enthalten. Der Phasendetektor 98 stellt an seinem Ausgang 103 eine Anlog- oder ein Digitalsignal bereit, das den Phasenunterschied zwischen der Spannung Uₐ und Uₛ widerspiegelt. Dieses Signal gelangt an den Steuereingang 72 des Generators 71, 85. Das Signal bewirkt, dass die Frequenz der durch den Generator 71, 85 bereitgestellten Spannung immer gleich der Frequenz Fₒ (Fₐ) ist. Das macht es möglich, den Motorbetrieb in einen breiten Temperaturbereich zu stabilisieren.

Die elektrische Erregervorrichtung 51, 74 kann mit einem PWM-Controler 107 der Versorgungsspannung E des Leistungsverstärkers ausgestattet sein, siehe Fig. 34. Beim Anlegen eines Analog- oder Digitalsignals an den Eingang 110 des PWM-Modulators 108 ändert sich die am Eingang 73 des Leistungsverstärkers 63 erscheinende Spannung E. Dadurch ändert sich die Amplitude der Spannung Uₐ. Dies führt zu einer Änderung des Erregerniveaus des Aktuators 1, wodurch sich die Bewegungsgeschwindigkeit des anzutreibenden Elementes 5 ändert.

Die Funktion des Filters 97, 106, des Phasendetektors 98, des Steuergenerators 71, 85 und des PWM-Modulators 108 kann durch in der digitalen Recheneinheit 113 abgelegte Programme realisiert werden.

Das anzutreibende Element 5 kann mit einem Lage- oder Geschwindigkeitsgeber 114 ausgerüstet sein. Überdies kann die elektrische Erregervorrichtung 51, 74 mit einem digitalen Controller 115 für die Lage oder die Geschwindigkeit des anzutreibenden Elementes 5 (siehe Fig. 35) ausgestattet sein. Der Controller 115 kann als separate Digitaleinheit oder als Programmteil in der digitalen Recheneinheit realisiert werden.

Bei einem Motor, dessen Erregervorrichtung den Geber 114 und den Controller 115 enthält, ist es möglich, das anzutreibende Element 5 mit hoher Präzision zu positionieren oder mit hoher Genauigkeit seine Geschwindigkeit vorzugeben.

Der erfindungsgemäße Aktuator 1 ist so ausgeführt, dass nur der Bereich 23 des Aktuators 1 eine Resonanzbewegung ausführt. Der übrige Bereich des Aktuators 1 führt keine Resonanzbewegung aus. Das bedeutet, dass die mittlere Schwingungsamplitude der Materialpunkte des Gebietes 23 größer als die mittlere Schwingungsamplitude der anderen Gebiete des Aktuators 1 ist. Deshalb sind die mechanischen Verluste durch innere Reibung in diesem Gebiet des Aktuators 1 kleiner als im Gebiet 23. Außerdem besitzt der Aktuator 1 des erfindungsgemäß ausgeführten Motors bei gleicher Resonanzlänge L ein geringeres Volumen als die Aktuatoren des bekannten Motors gemäß der veröffentlichten Druckschrift DE 10 2004 024 656 A1. Das verringert überdies die mechanischen Verluste im Aktuator 1. Davon ausgehend sind die allgemeinen mechanischen Verluste durch innere Reibung im Aktuator 1 geringer als die Verluste durch innere Reibung bei Aktuatoren anderer bekannter Motoren.

Die Verringerung der inneren Reibungsverluste ermöglicht es, bei gleicher Erregerspannung die Schwingungsgeschwindigkeit des Friktionselementes 3, d. h. die Bewegungsgeschwindigkeit eine anzutreibenden Elementes 5 zu erhöhen. Dadurch erhöht sich der Wirkungsgrad eines entsprechenden Motors. Da der zweite Seitenflächenbereich 12 eine Nicht-Resonanzoberfläche darstellt, ist die Schwingungsgeschwindigkeit der Materialpunkte dieser Oberfläche geringer als die der Materialpunkte auf der Aktuatoroberfläche bekannter Motoren. Dadurch verringern sich die mechanischen Verluste durch äußere Reibung in den Befestigungselementen 9 des Aktuators 1 bei Einsatz in einem entsprechenden Motor. Aufgrund der Verringerung der Verluste durch innere Reibung verringert sich die Erwärmung des Aktuators 1 und eines entsprechenden Motors. Die geringeren Verluste durch innere und äußere Reibung bedingt auch eine Verringerung der aktiven Komponente der elektrischen Eingangsimpedanz des erfindungsgemäßen Aktuators 1 im Verhältnis zur kapazitiven Komponente dieser Impedanz. Das wiederum verringert den Ladestrom der Eingangskapazität des Aktuators 1 und des kapazitiven Stromes im Verhältnis zur aktiven Komponente des durch den Aktuator 1 fließenden Stroms. Beides führt zu geringern Verlusten in einem Leistungsverstärker, wodurch sich die Erwärmung der Transistoren im Leistungsverstärker verringert. Im erfindungsgemäß ausgeführten Aktuator ist es möglich, die Generatoren der akustischen Welle direkt mit Brückenleistungsverstärker zu verbinden (ohne Trennfilter). Dies vereinfacht den Aufbau der elektrischen Erregervorrichtung, verringert die Erwärmung dieser und erhöht die Betriebssicherheit des Aktuators. Dadurch erweitet sich sein Einsatzgebiet.

## Patentansprüche

1. Aktuator (1) in Form einer Platte, umfassend wenigstens zwei Generatoren (2) zur Erregung einer akustischen Stehwelle im Aktuator (1), wobei der Aktuator (1) wenigstens zwei Hauptflächen (10) und eine senkrecht zu den Hauptflächen verlaufende Symmetrieebene S, bezüglich derer die Generatoren symmetrisch angeordnet sind, aufweist und an einem ersten, im Wesentlichen ebenen Seitenflächenbereich (11) des Aktuators (1) wenigstens ein Friktionselement (3) und/oder wenigstens eine Friktionsschicht (4), das/die zum Friktionskontakt mit einem anzutreibenden Element (5) vorgesehen ist/sind, angeordnet ist/sind und der erste Seitenflächenbereich (11) eine Länge L aufweist, die im Wesentlichen der Wellenlänge der im Aktuator (1) erregten akustischen Stehwelle entspricht
**dadurch gekennzeichnet,**
**dass** ein zweiter Seitenflächenbereich (12) des Aktuators (1) eine Länge B aufweist, die größer als die Wellenlänge der im Aktuator (1) erregten akustischen Stehwelle und ungleich einem Vielfachen der halben Wellenlänge der erregten akustischen Stehwelle ist.

2. Aktuator nach Anspruch 1, **dadurch gekennzeichnet, dass** der zweite Seitenflächenbereich (12) zumindest abschnittsweise gekrümmt ist und bevorzugt aus zumindest einem konkaven und/oder zumindest einem konvexen Abschnitt besteht.

3. Aktuator nach Anspruch 1, **dadurch gekennzeichnet, dass** der zweite Seitenflächenbereich (12) zumindest abschnittsweise eben ist und bevorzugt aus zwei oder mehr gegenüber dem ersten Seitenflächenbereich (11) unterschiedlich orientierten ebenen Abschnitten besteht.

4. Aktuator (1) nach einem der vorangegangenen Ansprüche, **dadurch gekennzeichnet, dass** auf dem zweiten Seitenflächenbereich (12) zumindest ein Punkt existiert, dessen Abstand zum Schnittpunkt der Symmetrieebene S mit dem ersten Seitenflächenbereich (11) im Wesentlichen der halben Wellenlänge der im Aktuator erregten Welle entspricht.

5. Aktuator (1) nach einem der vorangegangenen Ansprüche, **dadurch gekennzeichnet, dass** das Friktionselement (3) und/oder die Friktionsschicht (4) symmetrisch bezüglich der Symmetrieebene S angeordnet ist/sind, und bevorzugt entlang des gesamten ersten Seitenflächenbereichs (11) angeordnet ist/sind.

6. Aktuator (1) nach einem der vorangegangenen Ansprüche, **dadurch gekennzeichnet, dass** dieser im Betrieb Schwingungen im Ultraschallbereich vollführt.

7. Aktuator (1) nach einem der vorangegangenen Ansprüche, **dadurch gekennzeichnet, dass** dieser einschichtig oder mehrschichtig ist, wobei die Schicht/Schichten ein piezoelektrisches Material, vorzugsweise ein piezokeramisches Material aufweist/aufweisen.

8. Motor mit zumindest einem Aktuator (1) nach einem der vorangegangenen Ansprüche, zusätzlich aufweisend ein anzutreibendes Element (5) und eine elektrische Erregervorrichtung (51, 74).

9. Motor nach Anspruch 8, **dadurch gekennzeichnet, dass** der Motor vier Aktuatoren (1) jeweils in Form eines gleichschenkeligen Trapezes aufweist, wobei diese so angeordnet sind, dass sie ein Malteserkreuz bilden.

10. Motor nach Anspruch 9, **dadurch gekennzeichnet, dass** die Aktuatoren (1) miteinander mit Hilfe eines Verbindungselementes (43) verbunden sind, wobei das Verbindungselement (43) zumindest abschnittsweise Kontakt mit dem zweiten Seitenflächen bereich (12) jedes Aktuators (1) hat.

11. Motor nach Anspruch 10, **dadurch gekennzeichnet, dass** das Verbindungselement (43) ein schallisolierendes Material aufweist und vorzugsweise aus diesem besteht., wobei das schallisolierende Material vorzugsweise eine Oxidkeramik ist oder aus dem gleichen Material wie der Aktuator (1) besteht.

12. Motor nach einem der Ansprüche 8 bis 11, **dadurch gekennzeichnet, dass** der Aktuator (1) ein Rückkopplungselement (86) aufweist.

13. Motor nach einem der Ansprüche 8 bis 12, **dadurch gekennzeichnet, dass** die elektrische Erregervorrichtung (51, 74) eine periodische asymmetrische elektrische Spannung bereitstellt, wobei die Generatoren (2) gegenphasig miteinander verbunden sind;

14. Motor nach einem der Ansprüche 8 bis 13, **dadurch gekennzeichnet, dass** das anzutreibende Element (5) einen Geber (114) für die Lage oder für die Bewegungsgeschwindigkeit des anzutreibenden Elementes (5) aufweist und die elektrische Erregervorrichtung (51, 74) mit einem digitalen Controller (115) für die Lage oder die Bewegungsgeschwindigkeit des anzutreibenden Elementes (5) ausgestattet ist.

15. Motor nach Anspruch 14, **dadurch gekennzeichnet, dass** der digitale Controller (115) für die Lage oder die Bewegungsgeschwindigkeit des anzutreibenden Elementes (5) softwaremäßig in einer digitalen Recheneinheit (113) realisiert wird.

## Claims

1. Actuator (1) in the form of a plate, comprising at least two generators (2) for exciting an acoustic standing wave in the actuator (1), wherein the actuator (1) has at least two main surfaces (10) and a plane of symmetry S running perpendicularly to the main surfaces, with respect to which plane of symmetry S the generators are arranged symmetrically and, arranged on a first substantially flat lateral surface area (11) of the actuator (1), at least one friction element (3) and / or at least one friction layer (4) which is / are provided for friction contact with an element (5) to be driven, and wherein the first lateral surface area (11) has a length L that substantially corresponds to the wavelength of the acoustic standing wave excited in the actuator (1), **characterised in that**
a second lateral surface area (12) of the actuator (1) has a length B that is greater than the wavelength of the acoustic standing wave excited in the actuator (1) and that is not equal to a multiple of half the wavelength of the excited acoustic standing wave.

2. Actuator according to claim 1, **characterised in that** the second lateral surface area (12) is curved at least in sections and preferably consists of at least one concave and / or at least one convex section.

3. Actuator according to claim 1, **characterised in that** the second lateral surface area (12) is flat at least in sections and preferably consists of two or more flat sections that are aligned differently with respect to the first lateral surface area (11).

4. Actuator (1) according to one of the preceding claims, **characterised in that** at least one point exists on the second lateral surface area (12), wherein the distance between this point and the intersection point of the plane of symmetry S with the first lateral surface area (11) substantially corresponds to half the wavelength of the wave excited in the actuator.

5. Actuator (1) according to one of the preceding claims, **characterised in that** the friction element (3) and / or the friction layer (4) is / are arranged symmetrically with respect to the plane of symmetry S and is / are preferably arranged along the entire first lateral surface area (11).

6. Actuator (1) according to one of the preceding claims, **characterised in that** this performs oscillations in the ultrasound range during operation.

7. Actuator (1) according to one of the preceding claims, **characterised in that** this has a single layer or multiple layers, wherein the layer / layers has / have a piezoelectric material, preferably a piezoceramic material.

8. Motor with at least one actuator (1) according to one of the preceding claims, additionally having an element (5) to be driven and an electrical excitation device (51, 74).

9. Motor according to claim 8, **characterised in that** the motor has four actuators (1), each in the form of an isosceles trapezium, wherein these are arranged such that they form a Maltese cross.

10. Motor according to claim 9, **characterised in that** the actuators (1) are connected to one another with the help of a connection element (43), wherein the connection element (43) has contact with the second lateral surface area (12) of each actuator (1) at least in sections.

11. Motor according to claim 10, **characterised in that** the connection element (43) has a sound-insulating material and preferably is made of the same, wherein the sound-insulating material is preferably an oxide ceramic or is made of the same material as the actuator (1).

12. Motor according to one of the claims 8 to 11, **characterised in that** the actuator (1) has a feedback element (86).

13. Motor according to one of the claims 8 to 12, **characterised in that** the electrical excitation device (51, 74) provides a periodic asymmetrical electrical voltage, wherein the generators (2) are connected to each other with inverse phases.

14. Motor according to one of the claims 8 to 13, **characterised in that** the element (5) to be driven has an encoder (114) for the position or for the speed of movement of the element (5) to be driven and the electrical excitation device (51, 74) is equipped with a digital controller (115) for the position or the speed of movement of the element (5) to be driven.

15. Motor according to claim 14, **characterised in that** the digital controller (115) for the position or the speed of movement of the element (5) to be driven is implemented by means of software in a digital arithmetic unit (113).

## Revendications

1. Actionneur (1) sous la forme d'une plaque, comprenant au moins deux générateurs (2) pour l'excitation d'une onde stationnaire acoustique dans l'actionneur (1), l'actionneur (1) présentant au moins deux surfaces principales (10) et un plan de symétrie S, qui s'étend perpendiculairement aux surfaces principales et par rapport auquel les générateurs sont agencés de manière symétrique, et l'ensemble étant tel, que sur une première zone de surface latérale (11) sensiblement plane de l'actionneur (1) est/sont agencé(s) au moins un élément de friction (3) et/ou au moins une couche de friction (4), qui est/sont prévu(s) pour un contact de friction avec un élément (5) à entraîner, et tel que la première zone de surface latérale (11) présente une longueur L, qui correspond sensiblement à la longueur d'onde de l'onde stationnaire acoustique amorcée par excitation dans l'actionneur (1),
**caractérisé**
**en ce qu'**une deuxième zone de surface latérale (12) de l'actionneur (1) présente une longueur B, qui est plus grande que la longueur d'onde de l'onde stationnaire acoustique amorcée par excitation dans l'actionneur (1), et n'est pas égale à un multiple de la demi-longueur d'onde de l'onde stationnaire acoustique amorcée par excitation.

2. Actionneur selon la revendication 1, **caractérisé en ce que** la deuxième zone de surface latérale (12) est de configuration courbe au moins par secteurs, et est de préférence constituée d'au moins un secteur concave et/ou d'au moins un secteur convexe.

3. Actionneur selon la revendication 1, **caractérisé en ce que** la deuxième zone de surface latérale (12) est de configuration plane au moins par secteurs, et est de préférence constituée de deux secteurs plans ou davantage orientés différemment par rapport à la première zone de surface latérale (11).

4. Actionneur selon (1) l'une des revendications précédentes, **caractérisé en ce que** sur la deuxième zone de surface latérale (12) existe au moins un point dont la distance au point d'intersection du plan de symétrie S avec la première zone de surface latérale (11) correspond sensiblement à la demi longueur d'onde de l'onde amorcée par excitation dans l'actionneur.

5. Actionneur (1) selon l'une des revendications précédentes, **caractérisé en ce que** l'élément de friction (3) et/ou la couche de friction (4) est/sont agencé(s) de manière symétrique par rapport au plan de symétrie S, et est/sont de préférence agencé(s) le long de la totalité de la première zone de surface latérale (11).

6. Actionneur (1) selon l'une des revendications précédentes, **caractérisé en ce qu'**en fonctionnement, celui-ci exécute des oscillations dans le domaine des ultrasons.

7. Actionneur (1) selon l'une des revendications précédentes, **caractérisé en ce que** celui-ci est à une couche ou à couches multiples, la couche/les couches comprenant un matériau céramique, de préférence un matériau piézocéramique.

8. Moteur comprenant au moins un actionneur (1) selon l'une des revendications précédentes, et comprenant, en outre, un élément (5) à entraîner et un dispositif d'excitation électrique (51, 74).

9. Moteur selon la revendication 8, **caractérisé en ce que** le moteur comprend quatre actionneurs (1), chacun sous la forme d'un trapèze isocèle, ceux-ci étant agencés de manière à former une croix de malte.

10. Moteur selon la revendication 9, **caractérisé en ce que** les actionneurs (1) sont reliés mutuellement au moyen d'un élément de liaison (43), l'élément de liaison (43) étant en contact, au moins par secteurs, avec la deuxième zone de surface latérale (12) de chaque actionneur (1).

11. Moteur selon la revendication 10, **caractérisé en ce que** l'élément de liaison (43) comprend un matériau d'isolation acoustique et est de préférence constitué par celui-ci, le matériau d'isolation acoustique étant de préférence une céramique d'oxyde ou étant constitué du même matériau que l'actionneur (1).

12. Moteur selon l'une des revendications 8 à 11, **caractérisé en ce que** l'actionneur (1) comprend un élément de rétroaction (86).

13. Moteur selon l'une des revendications 8 à 12, **caractérisé en ce que** le dispositif d'excitation électrique (51, 74) fournit une tension électrique périodique asymétrique, les générateurs (2) étant reliés mutuellement en opposition de phase.

14. Moteur selon l'une des revendications 8 à 13, **caractérisé en ce que** l'élément à entraîner (5) comporte un capteur (114) pour la position ou pour la vitesse de mouvement de l'élément à entraîner (5), et le dispositif d'excitation électrique (51, 74) est équipé d'une unité de commande et de régulation numérique (115) pour la position ou la vitesse de mouvement de l'élément à entraîner (5).

15. Moteur selon la revendication 14, **caractérisé en ce que** l'unité de commande et de régulation numérique (115) pour la position ou la vitesse de mouvement de l'élément à entraîner (5) est réalisée sous forme de logiciel dans une unité de calcul numérique (113).
